# EUROPEAN PATENT APPLICATION

(11) **EP 3 376 589 A1**
(43) Date of publication of application: **19.09.2018**
(21) Application number: 16864139.7
(22) Date of filing: 04.11.2016
(51) Int. Cl.: H01P 1/387

(54) **IRREVERSIBLE CIRCUIT ELEMENT, IRREVERSIBLE CIRCUIT DEVICE, AND METHOD FOR MANUFACTURING SAID ELEMENT AND DEVICE**

(30) Priority: 12.11.2015 JP 2015222062
(71) Applicant: Mitsubishi Electric Corporation, Chiyoda-ku Tokyo 100-8310 (JP)
(72) Inventor: KITAMURA, Yoichi, Tokyo 100-8310 (JP); UEDA, Tetsuya, Tokyo 100-8310 (JP); SHIBATA, Hironobu, Tokyo 100-8310 (JP); TARUI, Yukinobu, Tokyo 100-8310 (JP)
(74) Representative: Trinks, Ole
(86) International application number: PCT/JP2016/082859
(87) International publication number: WO 2017/082178

(57) **Abstract**

An irreversible circuit element (P1) that can reduce manufacturing costs by preventing faults that lead to product defects includes a magnetic body (10), a magnetic body securing casing (20), and a magnet (50). The magnetic body securing casing (20) is arranged so as to surround the magnetic body (10). The magnet (50) is arranged on one side of the magnetic body (10). The magnetic body securing casing (20) includes a first electrode (21) on one casing main surface arranged on the one side, a second electrode (22) on the other casing main surface arranged on the other side opposite to the one side, and a through-conductor (23) that passes through the magnetic body securing casing (20) and electrically connects the first electrode (21) to the second electrode (22). The first electrode (21) is connected to a first wiring (32) arranged on the one side of the magnetic body (10).

## Description

### TECHNICAL FIELD

The present invention relates to an irreversible circuit element, an irreversible circuit device, and a method for manufacturing the element and the device. In particular, the present invention relates to a surface-mounted irreversible circuit element, an irreversible circuit device, and a method for manufacturing the element and the device.

### BACKGROUND ART

An irreversible circuit element is known as a high-frequency communication device that uses high-frequency electromagnetic waves with a short wavelength such as microwaves or millimeter-waves. Examples of the irreversible circuit element include an irreversible circuit element that is characteristic of a high-frequency circuit, such as an isolator or a circulator. The irreversible circuit element is an element in which an irreversible circuit is formed by utilizing the Faraday effect that occurs when a high-frequency electrical signal passes through a magnetic body such as ferrite and a region adjacent to the magnetic body.

In recent years, more downsized, weight-reduced, and thinner communication devices have been strongly demanded, and this is no exception in the irreversible circuit element. Consequently, it is required for the irreversible circuit element to be manufactured at a lower cost than before, to have high reliability, and to be downsized so as to be surface-mounted on a circuit board together with other electronic components for high-frequency devices.

For example, Japanese Patent Laying-Open No. H09-116309 (PTD 1) discloses a method for easily achieving surface-mounting of an irreversible circuit element. Specifically, in Japanese Patent Laying-Open No. H09-116309, a through-hole passing through a magnetic body is formed. A conductor material formed in the through-hole enables a conductor formed on a front surface of a ferrite substrate functioning as a magnetic body to conduct with a conductor on a rear surface of the ferrite substrate. As a result, surface mounting of the irreversible circuit element is achieved.

### CITATION LIST

### PATENT DOCUMENT

PTD 1: Japanese Patent Laying-Open JP H09-116309

### SUMMARY OF INVENTION

### TECHNICAL PROBLEMS

A magnetic body such as ferrite is composed of ceramics containing iron oxide as the main component. For this reason, the magnetic body has high hardness and is easily broken or chipped. It is thus difficult to machine a through-hole in the magnetic body and it requires high cost for the machining. In addition, a product yield may be reduced by broken or chipped magnetic bodies described above. Moreover, the product yield may also be reduced because adhesive force of a copper-plated film to a wall surface of the through-hole is small and thus the copper-plated film is easily peeled from the wall surface. With the reduction in product yield, manufacturing costs may be increased.

The present invention has been achieved in view of the above problems, and an object of the invention is to provide an irreversible circuit element, an irreversible circuit device, and a method for manufacturing the element and the device that can reduce manufacturing costs by preventing faults that lead to product defects.

### SOLUTIONS TO PROBLEMS

An irreversible circuit element of the present invention includes a magnetic body, a magnetic body securing casing, and a magnet. The magnetic body securing casing is arranged so as to surround the magnetic body. The magnet is arranged on one side of the magnetic body. The magnetic body securing casing includes a first electrode on one casing main surface arranged on the one side, a second electrode on the other casing main surface arranged on the other side opposite to the one side, and a through-conductor that passes through the magnetic body securing casing and electrically connects the first electrode to the second electrode. The first electrode is connected to a first wiring arranged on the one side of the magnetic body.

The irreversible circuit device of the present invention further includes a solder ball arranged on a surface of the other side of the magnetic body securing casing in the irreversible circuit element described above. A circuit board joined to the other side of the solder ball is arranged. The circuit board includes a second wiring. The second electrode is connected to the second wiring arranged on the other side of the magnetic body.

According to a method for manufacturing an irreversible circuit element of the present invention, a magnetic body is prepared first and a magnetic body securing casing is arranged so as to surround the magnetic body. A magnet is arranged on one side of the magnetic body. A first electrode is formed on one casing main surface arranged on the one side of the magnetic body securing casing. A second electrode is formed on the other casing main surface arranged on the other side of the magnetic body securing casing opposite to the one side. A through-conductor that passes through the magnetic body securing casing and electrically connects the first electrode to the second electrode is formed. The first electrode is connected to a first wiring arranged on the one side of the magnetic body.

According to a method for manufacturing an irreversible circuit device of the present invention, a solder ball is arranged on a surface on the other side of the magnetic body securing casing in the irreversible circuit element described above. A circuit board is joined to the solder ball. The circuit board is formed so as to include a second wiring. The second electrode is connected to the second wiring arranged on the other side of the magnetic body.

### ADVANTAGEOUS EFFECTS OF INVENTION

According to the present invention, a through-hole and a through-conductor that pass through a magnetic body securing casing are formed in the magnetic body securing casing, and thus it is not necessary to form a through-hole in a magnetic body. It is thus possible to provide an irreversible circuit element, an irreversible circuit device, and a method for manufacturing the element and the device in which machining of forming a through-hole is easy, faults and defects are reduced, and manufacturing costs are reduced.

### BRIEF DESCRIPTION OF DRAWINGS

- FIG. 1: is a schematic perspective view of an irreversible circuit device according to the present invention.
- FIG. 2: is a schematic cross-sectional view taken along a line II-II of FIG. 1 in a first embodiment.
- FIG. 3: is a schematic perspective view of an assembled state of members constituting the irreversible circuit device of the first embodiment shown in FIGs. 1 and 2.
- FIG. 4: is a schematic perspective view of a magnetic body according to the present invention.
- FIG. 5(A): is a schematic top view of a magnetic body according to first to third embodiments.
- FIG. 5(B): is a schematic bottom view of the magnetic body according to the first to third embodiments.
- FIG. 5(C): is a schematic cross-sectional view of the magnetic body according to the first to third embodiments.
- FIG. 5(D): shows a modification of a configuration of the magnetic body according to the first to third embodiments.
- FIG. 6: is a schematic perspective view of a magnetic body securing casing according to the first to third embodiments.
- FIG. 7(A): is a schematic top view of the magnetic body securing casing according to the first to third embodiments.
- FIG. 7(B): is a schematic bottom view of the magnetic body securing casing according to the first to third embodiments.
- FIG. 8(A): shows a schematic plan view and a schematic cross-sectional view illustrating a first example of an aspect of an arrangement of a solder resist in a region overlapping a casing lower-surface electrode.
- FIG. 8(B): shows a schematic plan view and a schematic cross-sectional view illustrating a second example of the aspect of the arrangement.
- FIG. 9: is a schematic cross-sectional view of an aspect of an arrangement of a solder resist and a cavity in a region other than the region overlapping a casing lower-surface electrode.
- FIG. 10(A): is a schematic top view obtained by adding a magnetic body to FIG. 7(A).
- FIG. 10(B): is a schematic bottom view obtained by adding the magnetic body to FIG. 7(B).
- FIG. 11: is a schematic perspective view of a thin board according to the present invention.
- FIG. 12(A): is a schematic top view of the thin board according to the present invention.
- FIG. 12(B): is a schematic bottom view of the thin board according to the present invention.
- FIG. 13: is a schematic top view of a circuit board according to the present invention.
- FIG. 14: is a schematic view illustrating a step of a manufacturing method according to the first embodiment, or a step of supplying an elastic adhesive to a magnetic body securing casing.
- FIG. 15: is a schematic view illustrating a step of the manufacturing method according to the first embodiment, or a step of securing a magnetic body to the magnetic body securing casing.
- FIG. 16: is a schematic perspective view illustrating a step of the manufacturing method according to the first embodiment, or a step of arranging a thin board and an ACF.
- FIG. 17: shows a step of the manufacturing method according to the first embodiment, and shows a state where members arranged as shown in FIG. 16 are adhesion-secured as viewed from the top.
- FIG. 18(A): is a schematic perspective view of a state before an ACF used in the manufacturing method according to the first embodiment is adhesion-secured.
- FIG. 18(B): is a schematic top view of the state before the ACF is adhesion-secured.
- FIG. 18(C): is a schematic side view or a schematic cross-sectional view of the state before the ACF is adhesion-secured.
- FIG. 19: is a schematic cross-sectional view illustrating a step of the manufacturing method according to the first embodiment, or a first step of a step of bonding a thin board to a magnetic body securing casing by a bonder.
- FIG. 20: is a schematic cross-sectional view illustrating a step of the manufacturing method according to the first embodiment, or a second step of the step of bonding a thin board to a magnetic body securing casing by a bonder.
- FIG. 21: is a schematic cross-sectional view illustrating a step of the manufacturing method according to the first embodiment, or a third step of the step of bonding a thin board to a magnetic body securing casing by a bonder.
- FIG. 22: is a schematic cross-sectional view illustrating a step of the manufacturing method according to the first embodiment, or a fourth step of the step of bonding a thin board to a magnetic body securing casing by a bonder.
- FIG. 23: is a schematic cross-sectional view illustrating a step of the manufacturing method according to the first embodiment, or a fifth step of the step of bonding a thin board to a magnetic body securing casing by a bonder.
- FIG. 24: is a schematic cross-sectional view illustrating a step of the manufacturing method according to the first embodiment, or a sixth step of the step of bonding a thin board to a magnetic body securing casing by a bonder.
- FIG. 25: is a schematic cross-sectional view illustrating a step of the manufacturing method according to the first embodiment, or a seventh step of the step of bonding a thin board to a magnetic body securing casing by a bonder.
- FIG. 26: is a schematic cross-sectional view illustrating a step of the manufacturing method according to the first embodiment, or an eighth step of the step of bonding a thin board to a magnetic body securing casing by a bonder.
- FIG. 27: is a schematic cross-sectional view illustrating a step of the manufacturing method according to the first embodiment, or a first step of an adhesion step of a solder ball to an irreversible circuit element.
- FIG. 28: is a schematic cross-sectional view illustrating a step of the manufacturing method according to the first embodiment, or a second step of the adhesion step of a solder ball to an irreversible circuit element.
- FIG. 29: is a schematic cross-sectional view illustrating a step of the manufacturing method according to the first embodiment, or a third step of the adhesion step of a solder ball to an irreversible circuit element.
- FIG. 30: is a schematic cross-sectional view illustrating a step of the manufacturing method according to the first embodiment, or a fourth step of the adhesion step of a solder ball to an irreversible circuit element.
- FIG. 31: is a schematic top view of a magnetic body securing casing included in an irreversible circuit device according to a modification of the first embodiment.
- FIG. 32: is a schematic cross-sectional view taken along the line II-II of FIG. 1 in a second embodiment.
- FIG. 33: is a schematic perspective view illustrating a step of a manufacturing method according to the second embodiment, or a step of arranging a thin board, an insulating adhesive film, and a conductive adhesive.
- FIG. 34: shows a step of the manufacturing method according to the second embodiment, and shows a state where members arranged as shown in FIG. 33 are adhesion-secured as viewed from the top.
- FIG. 35: is a schematic cross-sectional view taken along the line II-II of FIG. 1 in a third embodiment.
- FIG. 36: is a schematic perspective view illustrating a step of a manufacturing method according to the third embodiment, or a step of arranging a thin board, an insulating liquid adhesive, and a pre-coated solder.
- FIG. 37: shows a step of the manufacturing method according to the third embodiment, and shows a state where members arranged as shown in FIG. 36 are adhesion-secured as viewed from the top.
- FIG. 38: is a schematic plan view illustrating a step of the manufacturing method according to the third embodiment and a configuration for preventing a short-circuit caused by a spreading pre-coated solder, as viewed from the top.
- FIG. 39: is a schematic cross-sectional view taken along the line II-II of FIG. 1 in a fourth embodiment.
- FIG. 40: is a schematic top view of a lower casing according to the fourth embodiment.
- FIG. 41(A): is a schematic top view of a magnetic body according to fourth to sixth embodiments.
- FIG. 41(B): is a schematic bottom view of the magnetic body according to the fourth to sixth embodiments.
- FIG. 41(C): is a schematic cross-sectional view of the magnetic body according to the fourth to sixth embodiments.
- FIG. 42: is a schematic cross-sectional view taken along the line II-II of FIG. 1 in a fifth embodiment.
- FIG. 43: is a schematic cross-sectional view taken along the line II-II of FIG. 1 in a sixth embodiment.

### DESCRIPTION OF EMBODIMENTS

The present embodiments are described below based on the drawings.

### First Embodiment

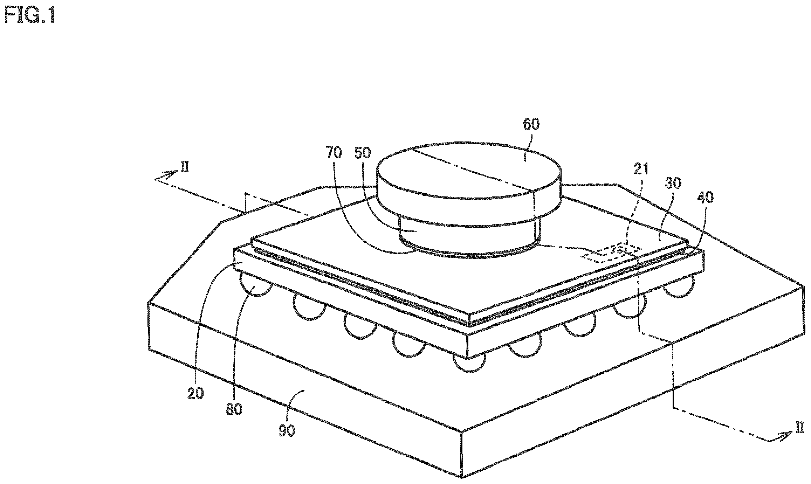

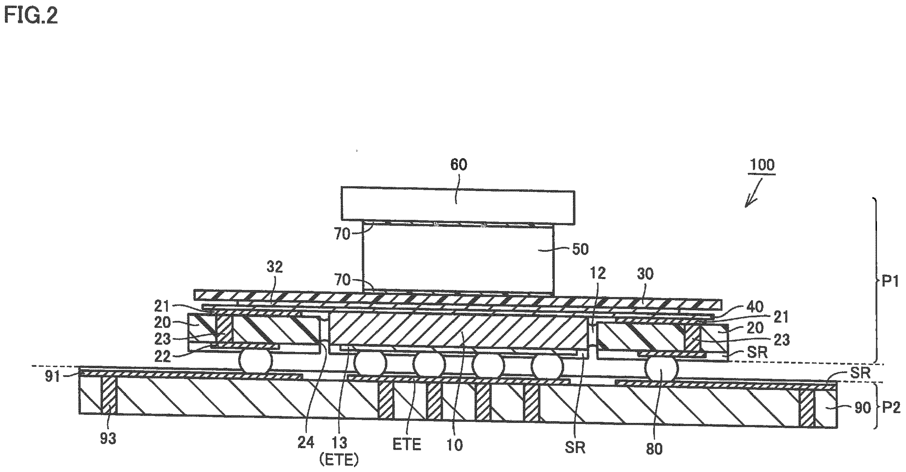

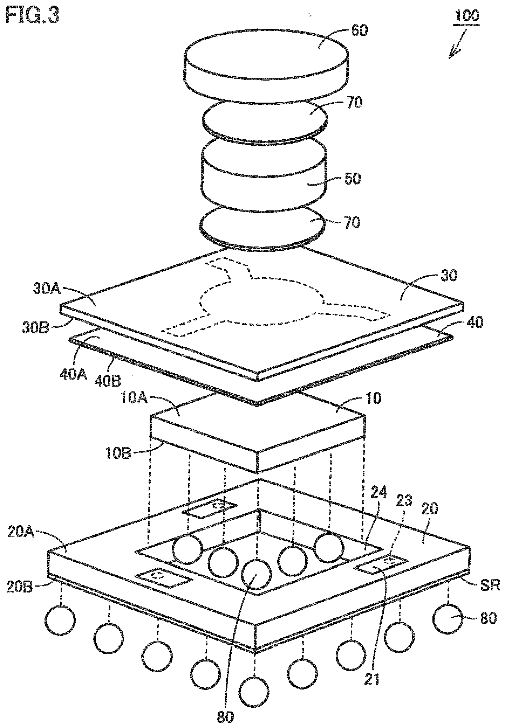

Configurations of an irreversible circuit device according to the present embodiment and an irreversible circuit element included in the irreversible circuit device are described first. FIG. 1 shows an aspect of the overall appearance of the irreversible circuit device. FIG. 2 shows an aspect of a cross-section taken along a line II-II of FIG. 1. FIG. 3 shows an aspect of an arrangement of members constituting the irreversible circuit device. The left-right direction in FIG. 2 corresponds to a direction along a direction in which a part along a one-dot chain line of FIG. 1 (in particular, in an irreversible circuit element P1) extends, that is, an elongated conductor terminal included in a conductor thin film 32 formed in a thin board 30 to be described later extends.

Referring to FIGs. 1 and 2, an irreversible circuit device 100 according to the present embodiment includes irreversible circuit element P1 and a mounted part P2. Irreversible circuit element P1 mainly includes a magnetic body 10, a magnetic body securing casing 20, thin board 30, an ACF 40, a magnet 50, a yoke 60, and an adhesive film 70. Irreversible circuit element P1 is surface-mounted on mounted part P2 functioning as a circuit board 90 by solder balls 80. These members are basically arranged at positions shown in FIG. 3 and assembled, thus constituting irreversible circuit device 100 shown in FIGs. 1 and 2. Configurations of the constituent members described above and the like are described below.

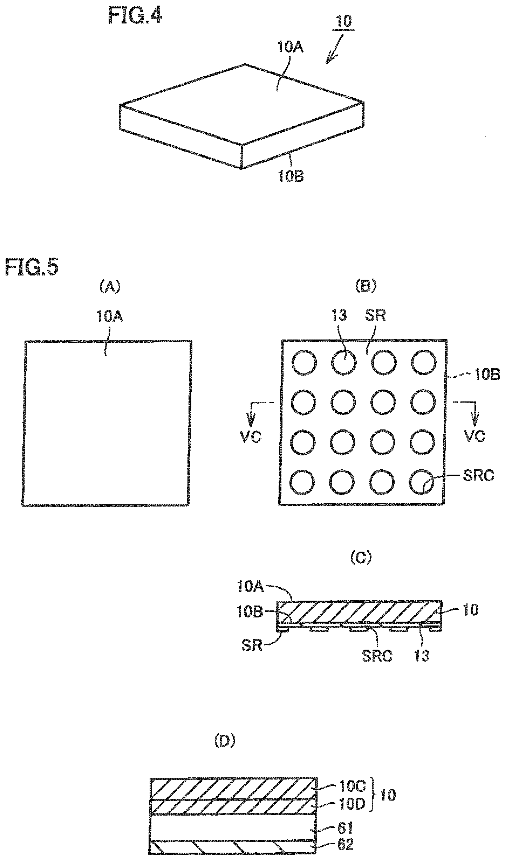

FIG. 4 shows an aspect of the appearance of magnetic body 10. FIGs. 5(A) and 5(B) show the planar shape of magnetic body 10 (including a rear conductor 13 adjacent to magnetic body 10 and the like). FIG. 5(C) is a schematic cross-sectional view taken along a line VC-VC of FIG. 5(B). Referring to FIGs. 1 to 3 and 4 to 5, magnetic body 10 is a plate-like member having, for example, a quadrangular (square) planar shape, and has, in a planar view, a horizontal direction (a left-right direction of FIG. 5(A)) size of 4 mm, a vertical direction (an up-down direction of FIG. 5(A)) size of 4 mm, and a thickness direction (an up-down direction of FIG. 5(C)) size of 0.5 mm. The outline size and shape of magnetic body 10 described above are only an example, and may be changed according to the specifications required for a circuit such as a frequency band for use with irreversible circuit element P1, power resistance, and the like. For example, magnetic body 10 may have a polygonal shape other than a quadrangular shape or a circular shape in a planar view.

As shown in FIG. 5(C) and the like, magnetic body 10 may be constituted by a single layer. However, referring to FIG. 5(D), magnetic body 10 may include a plurality of magnetic body layers 10C and 10D and these layers may be laminated in magnetic body 10. In FIG. 5(D), while magnetic body 10 is constituted by laminating the two magnetic body layers 10C and 10D, magnetic body 10 may be configured to include three or more magnetic body layers.

For example, a lower yoke 61 may be adhesion-secured to a lower side (other side) of magnetic body 10 including magnetic body layers 10C and 10D, that is, to a lower side of magnetic body layer 10D that is the bottom layer. Lower yoke 61 has a similar planar shape to magnetic body 10, is a metal plate composed of the same material (a metal material) as yoke 60 to be described later in detail, and has similar functions to yoke 60. A metal plate 62 may be further adhesion-secured to a lower side of lower yoke 61. However, metal plate 62 functions as a heat sink that temporarily accumulates therein heat that is secondarily generated by energy losses when irreversible circuit device 100 is electrically operated. Metal plate 62 does not need to be provided. Only lower yoke 61 may be adhesion-secured to the lower side of magnetic body layers 10C and 10D and lower yoke 61 may function as a heat sink instead of metal plate 62.

As described above, according to the present embodiment, at least one metal plate may be joined to the lower side of magnetic body 10 including magnetic body layers 10C and 10D.

Magnetic body 10 is composed of any one selected from the group constituting of a metal material containing iron as the main component, ferrite, and a composite magnetic material obtained by mixing magnetic power and a resin. However, ferrite is most widely used as the constituent material of magnetic body 10. When ferrite is used as the constituent material of magnetic body 10, for example, rare earth garnet ferrite that is known as a material having a low magnetic loss in a high-frequency region may be used.

As shown in FIG. 5(A), the base of, for example, ferrite constituting magnetic body 10 is exposed on a magnetic body main surface 10A on an upper side (one side) of magnetic body 10. Meanwhile, rear conductor 13 that is a thin film layer (an electrode) with the earth potential is uniformly formed on the substantially overall surface of the base of magnetic body 10, for example ferrite, constituting a magnetic body main surface 10B on the lower side (other side) of magnetic body 10. Rear conductor 13 is arranged on only magnetic body main surface 10B on the lower side of magnetic body 10 and is not arranged on magnetic body main surface 10A on the upper side of magnetic body 10. Manufacturing costs and the like can thus be reduced as compared to a case of forming rear conductor 13 on both magnetic body main surfaces 10A and 10B. When magnetic body 10, lower yoke 61, and metal plate 62 are provided as shown in FIG. 5(D), rear conductor 13 may be arranged on only the lower side (other side) of metal plate 62 that is the bottom layer.

Rear conductor 13 is constituted by a copper thin film having a thickness of, for example, approximately 3 µm, a nickel thin film formed on a surface of the copper thin film having a thickness of, for example, 1 µm or more and 2 µm or less, and a gold thin film formed on a surface of the nickel thin film having a thickness of, for example, approximately 0.02 µm. The nickel thin film and gold thin film on the surface of the copper thin film are applied for preventing the oxidization of rear conductor 13 and improving solder wettability.

In particular, as shown in FIG. 5(B), a solder resist SR is formed on only magnetic body main surface 10B on the lower side of magnetic body 10. As described above, rear conductor 13 is formed on magnetic body main surface 10B and thus solder resist SR is formed on a surface on the lower side of rear conductor 13 (on the other side, that is, a side of circuit board 90). Solder resist SR is formed for positioning at the time of mounting solder ball 80, and is composed of, for example, a generally known resin material. A solder resist cavity SRC in which solder resist SR is not arranged is formed in a region substantially overlapping a part to which solder ball 80 is joined. Although not shown in FIG. 5, a pad electrode may be formed in solder resist cavity SRC as described later.

Solder resist SR may be composed of a thin film of a metal material that is not wet with solder such as chromium or may be composed of an epoxy resin or a polyimide resin. It is particularly preferable that solder resist SR be composed of an epoxy resin or polyimide (resin) in the present embodiment. If solder resist SR is composed of an epoxy resin or a polyimide resin, it is possible to increase a stress reduction effect of solder resist SR. Specifically, while the thickness of solder resist SR composed of a resin is approximately equal to 30 µm or more and 40 µm or less, such a thickness is larger than the thickness of solder resist SR composed of a metal material. This thickness allows solder resist SR composed of a resin to cover and surround the part on which solder ball 80 is mounted. As a result, it is possible to increase an effect that solder resist SR reduces the stress applied to the region surrounding solder ball 80. That is, it is possible to reduce defects such as chipping or cracks problematic in magnetic body 10 when external force or thermal stress is applied to magnetic body 10.

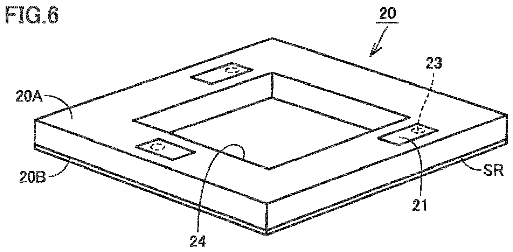

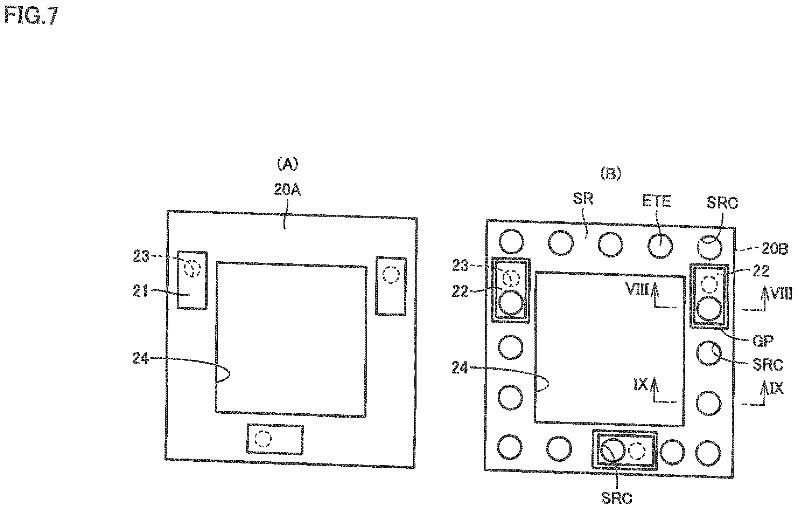

FIG. 6 shows an aspect of the appearance of magnetic body securing casing 20, and FIG. 7 shows the planar shape of magnetic body securing casing 20. Referring to FIGs. 1 to 3 and 6 to 7, magnetic body securing casing 20 according to the present embodiment is formed to have, for example, a quadrangular (square) planar shape. Magnetic body securing casing 20 according to the present embodiment includes, at its center part in a planar view, a securable part 24 that is shaped to fit the outline shape of magnetic body 10 (the square planar shape) so as to be capable of securing magnetic body 10 therein. Securable part 24 according to the present embodiment is formed as an opening that passes through magnetic body securing casing 20 from casing main surface 20A (one casing main surface) on the upper side (one side) of magnetic body securing casing 20 to a casing main surface 20B (other casing main surface) on the opposite side, that is, the lower side (other side) of magnetic body securing casing 20. Magnetic body securing casing 20 (securable part 24) can thus secure and surround magnetic body 10 in a planar view. That is to say, magnetic body 10 is secured to securable part 24 so as to be fitted into magnetic body securing casing 20.

Magnetic body securing casing 20 according to the present embodiment is formed in a frame shape having an opening passing through magnetic body securing casing 20. Magnetic body securing casing 20 is a printed board and has substantially the same thickness as magnetic body 10 secured to magnetic body securing casing 20. (The thickness of the main body of magnetic body securing casing 20 may be less than that of magnetic body 10 by the thickness of a first electrode that is formed in magnetic body securing casing 20 and is described later.) The planar shape of the outline of magnetic body securing casing 20 is not limited to the quadrangular shape (square shape) shown in FIG. 6 and may be freely selected. In addition, magnetic body securing casing 20 has, for example in a planar view, a horizontal direction (a left-right direction of FIG. 7(A)) size of 7.4 mm, a vertical direction (an up-down direction of FIG. 7(A)) size of 7.4 mm, and a thickness of 0.5 mm. Securable part 24 has, for example, a horizontal direction size of 4.4 mm, a vertical direction size of 4. 4 mm, and a thickness of 0.5 mm.

Magnetic body securing casing 20 according to the present embodiment is a commercially available printed board, and a high-frequency circuit for inputting and outputting electrical signals to and from overall irreversible circuit element P1 is formed on the printed board. For this reason, magnetic body securing casing 20 is composed of a material that has excellent high-frequency characteristics and a low dielectric loss. Specifically, for example, magnetic body securing casing 20 is composed of a dielectric material selected from the group consisting of a thermosetting resin printed board having a low dielectric loss, a fluororesin printed board, and a liquid crystal polymer printed board. The liquid crystal polymer printed board has a slightly higher dielectric loss and a slightly higher dielectric constant than the fluororesin printed board.

In view of achieving a surface-mounting irreversible circuit element, it is necessary to draw a first wiring of the irreversible circuit element arranged on one side of a magnetic body to a second wiring of the irreversible circuit element disposed on the other side of the magnetic body opposite to the one side, on which the irreversible circuit element is mounted so as to be connected to a circuit board of a mounted part. Magnetic body securing casing 20 includes, as constituent members of the high-frequency circuit described above, a casing upper-surface electrode 21 (first electrode) on casing main surface 20A, a casing lower-surface electrode 22 (second electrode) on casing main surface 20B, and a through-conductor 23. Through-conductor 23 passes through magnetic body securing casing 20 from casing upper-surface electrode 21 to casing lower-surface electrode 22, and electrically connects casing upper-surface electrode 21 to casing lower-surface electrode 22. That is, through-conductor 23 is formed for drawing various wirings of irreversible circuit element P1 arranged on the upper side of through-conductor 23 to a region on the lower side of through-conductor 23 to be electrically connectable to circuit board 90.

Referring to FIG. 7(B) in particular, similarly to magnetic body 10, solder resist SR is formed only on casing main surface 20B on the lower side of magnetic body securing casing 20 (in practice, immediately below casing main surface 20B). Solder resist cavity SRC in which solder resist SR is not arranged is formed in a region substantially overlapping a part to which solder ball 80 is joined. Not only casing lower-surface electrode 22 but also an earth electrode ETE is provided on casing main surface 20B. For example, earth electrode ETE of magnetic body securing casing 20 is formed as the same layer as casing lower-surface electrode 22. Earth electrode ETE is formed for the purpose of keeping the potential of the region on casing main surface 20B equal to the potential of earth electrode ETE formed on circuit board 90 below casing main surface 20B. As earth electrode ETE is provided, it is possible to improve characteristics of the high-frequency circuit of irreversible circuit element P1 and reliability in a connection part of solder ball 80. Solder resist cavity SRC is formed not only for connecting casing lower-surface electrode 22 to solder ball 80 but also for connecting earth electrode ETE to solder ball 80.

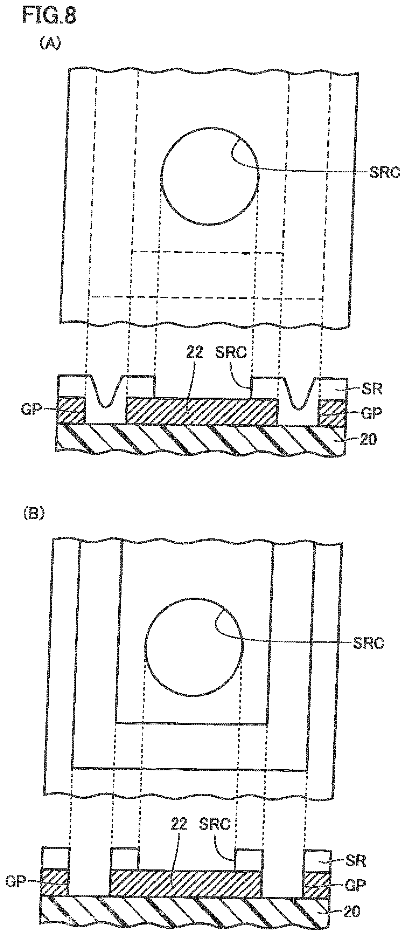

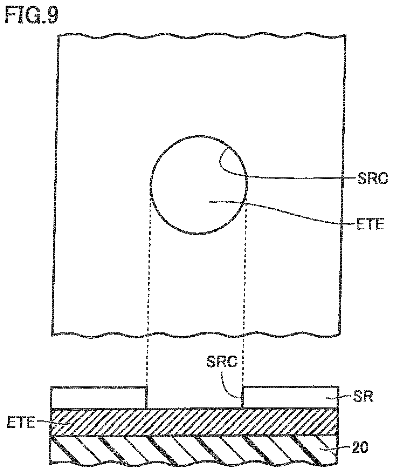

FIG. 8(A) shows a first example of the planar shape and cross-sectional shape of solder resist SR and solder resist cavity SRC in a part taken along a line VIII-VIII of FIG. 7(B), that is, in a region overlapping casing lower-surface electrode 22 and a region adjacent to the overlapping region. FIG. 8(B) shows a second example of the planar shape and cross-sectional shape of the part taken along the line VIII-VIII of FIG. 7(B). FIG. 9 shows an example of the cross-sectional shape of solder resist cavity SRC in a part taken along a line IX-IX of FIG. 7(B), that is, in a region other than the region overlapping casing lower-surface electrode 22.

Referring to FIGs. 8(A), 8(B), and 9, in practice, a thin film of a conductor material is formed on the substantially overall surface on the lower side of casing main surface 20B of magnetic body securing casing 20. However, this thin film of the conductor material is not present in a gap part GP formed in a rectangular frame shape, and the thin film of the conductor material in a region surrounded by gap part GP is independent from the thin film of the conductor material in other regions (that may function as earth electrode ETE) as island-like casing lower-surface electrode 22. The thin film of the conductor material described above other than casing lower-surface electrode 22 (that may function as earth electrode ETE) is omitted in FIG. 2.

Solder resist SR is also formed on the surface on the lower side of casing main surface 20B of magnetic body securing casing 20 to cover the thin film of the conductor material. In the first example of FIG. 8(A), solder resist SR is not arranged only in solder resist cavity SRC in casing lower-surface electrode 22, and solder resist SR is arranged to fill gap part GP. On the other hand, in the second example of FIG. 8(B), solder resist SR is not arranged in solder resist cavity SRC in casing lower-surface electrode 22 and in gap part GP. Any one of the aspects of FIGs. 8(A) and 8(B) may be employed. Although not shown in the drawings, an aspect may be employed in which solder resist SR is arranged only in a part of the region in gap part GP. In FIGs. 8 and 9, the thin film of the underlying conductor material is exposed in solder resist cavity SRC, and the exposed part functions as a pad electrode.

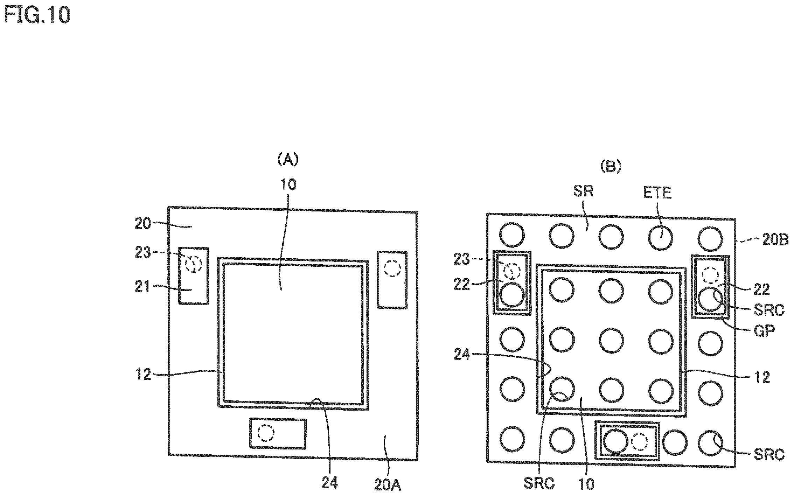

FIG. 10 shows an aspect in which magnetic body 10 is secured in securable part 24 of magnetic body securing casing 20 shown by the plan views of FIGs. 7(A) and 7(B). Magnetic body 10 is adhesion-secured to securable part 24 by an elastic adhesive 12 arranged between magnetic body 10 and an inner wall surface of securable part 24. That is to say, magnetic body 10 is connected to the inner wall surface of securable part 24 with elastic adhesive 12 interposed therebetween. As the inner wall surface of securable part 24 adheres to elastic adhesive 12, it is possible to secure the mechanical strength against a mechanical load such as a heat cycle between magnetic body 10 and magnetic body securing casing 20.

The linear expansion coefficient of a constituent member of magnetic body 10 is different from that of a constituent member of magnetic body securing casing 20. Specifically, for example, the linear expansion coefficient of magnetic body 10 composed of rare earth garnet ferrite is approximately 10 ppm/K whereas the linear expansion coefficient of magnetic body securing casing 20 composed of an epoxy resin printed board is approximately 16 ppm/K. For this reason, thermal stress is applied between magnetic body 10 and magnetic body securing casing 20 by a thermal load applied in a mounting step performed after an adhesion step of magnetic body 10 to magnetic body securing casing 20 and a change in an environmental temperature, so that damages such as cracks may occur in magnetic body 10 and magnetic body securing casing 20.

As described above, magnetic body 10 adheres to magnetic body securing casing 20 by elastic adhesive 12. Elastic adhesive 12 is preferably composed of a material in which a cured adhesive layer becomes a rubber-like elastic body. As a result, it is possible to reduce the thermal stress caused by a mismatch between the linear expansion coefficient of magnetic body 10 and the linear expansion coefficient of magnetic body securing casing 20.

All solder resist cavities SRC in magnetic body 10 and magnetic body securing casing 20 shown in FIG. 10 have substantially the same size. Solder balls 80 mounted in solder resist cavities SRC can thus have the same height and it is possible to prevent steps caused by differences in the height of solder balls 80.

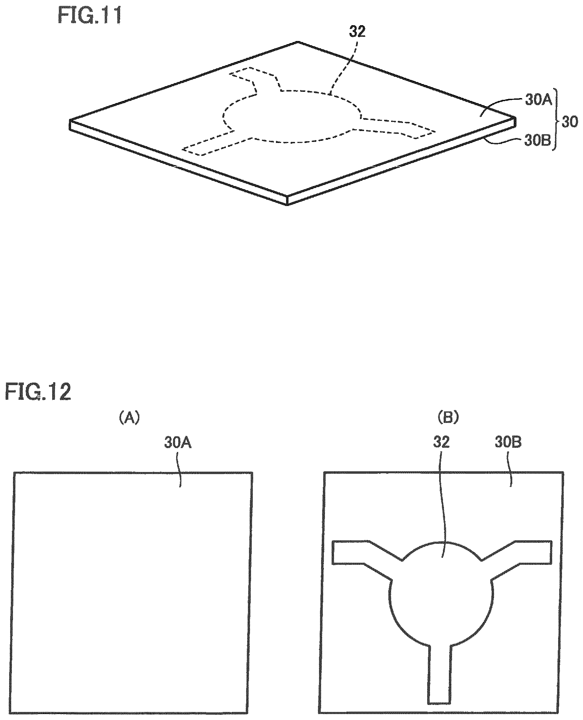

FIG. 11 shows an aspect of the appearance of thin board 30 and FIG. 12 shows the planar shape of thin board 30. Referring to FIGs. 1 to 3 and 11 to 12, thin board 30 is arranged on at least a part of the region on the upper side (one side) of magnetic body 10 and magnetic body securing casing 20, and at the same time is arranged on the region sandwiched between magnet 50 and magnetic body 10.

Thin board 30 is composed of, for example, a quadrangular (square) base material in a planar view and has, in a planar view, a horizontal direction (a left-right direction of FIG. 12(A)) size of 6.8 mm, a vertical direction (an up-down direction of FIG. 12(A)) size of 6.8 mm, and a thickness of 300 µm. Preferably, the size of thin board 30 in a planar view is thus slightly smaller than the size of an outer edge of magnetic body securing casing 20. Similarly to other members described above, however, the shape and size of thin board 30 are not limited thereto.

Thin board 30 is a plate-like member that contains an organic material having a low dielectric loss as the main component and has high flexibility. Specifically, thin board 30 is composed of any dielectric material selected from the group consisting of a thermosetting resin printed board having a low dielectric loss, a polyimide-based flexible printed board, a fluororesin printed board, and a liquid crystal polymer printed board. The thickness of thin board 30 is preferably approximately 25 µm or more and 300 µm or less.

Referring to FIGs. 11, 12(A), and 12(B) in particular, thin board 30 includes a thin board main surface 30A on an upper side (one side) of thin board 30 and a thin board main surface 30B on a lower side (other side) of thin board 30, similarly to other members described above. The base of a material constituting thin board 30 is exposed on overall thin board main surface 30A. Conductor thin film 32 is formed on a part of thin board main surface 30B. Conductor thin film 32 is constituted by a thin film containing copper as the main component and having a thickness of, for example, approximately 6 µm or more and 18 µm or less, a nickel thin film formed on a surface of the copper thin film having a thickness of, for example, 3 µm or more and 5 µm or less, and a gold thin film formed on a surface of the nickel thin film having a thickness of, for example, approximately 0.02 µm. The nickel thin film and gold thin film on the surface of the copper thin film are applied for preventing the oxidization of conductor thin film 32 and improving solder wettability.

As described above, conductor thin film 32 is formed only on thin board main surface 30B on the lower side of thin board 30 (the side of magnetic body 10). Therefore, in irreversible circuit element P1, conductor thin film 32 is arranged to oppose magnetic body 10 and magnetic body securing casing 20. In addition, in irreversible circuit device 100, conductor thin film 32 is arranged as a first wiring on the upper side (one side) of magnetic body 10 and magnetic body securing casing 20.

Referring to FIG. 12(B) in particular, conductor thin film 32 of thin board 30 includes a circular center conductor formed on the center part of thin board main surface 30B in a planar view and three linear conductors functioning as three conductor terminals radiating from the center conductor in three directions. The three linear conductors extend in directions apart from each other at approximately 120° with respect to the center of the circular center conductor. Some of the three linear conductors or all the three linear conductors may have a partially bent region on its distal end side opposite to its center conductor side.

A dielectric material composing thin board 30 functions as a structural material for supporting conductor thin film 32. Further, conductor thin film 32 functions as a part of a transmission line. The transmission line is configured by integrating magnetic body 10, magnetic body securing casing 20, and conductor thin film 32 of thin board 30 and cooperating with earth electrode ETE on the lower side of magnetic body 10. The dielectric material composing thin board 30 also functions to prevent an electromagnetic field generated by high-frequency signals passing through conductor thin film 32 from leaking to the side at which magnet 50 is arranged (upper side) and to improve electrical characteristics. Thin board 30 is thus preferably composed of a material having a low dielectric loss.

In view of characteristics of the transmission line described above, it is preferable that the upper-side main surfaces of magnetic body 10 and magnetic body securing casing 20 be joined to conductor thin film 32 of thin board 30 in a manner that the upper main surfaces and conductor thin film 32 are as close as possible.

Referring again to FIGs. 1 to 3, ACF 40 that functions as an adhesive member arranged between thin board 30 and magnetic body 10 (magnetic body securing casing 20) enables the upper-side main surfaces of magnetic body 10 and magnetic body securing casing 20 to be joined and secured to conductor thin film 32 of thin board 30 as close as possible.

ACF 40 (Anisotropic Conductive Film) is a film member having, for example, a quadrangular (square) planar shape, similarly to other members described above. ACF 40 is a semi-cured thermosetting resin film formed by kneading fine metal particles having a diameter of approximately 10 µm or less or resin particles having a metal thin film formed on their surfaces into a film-like adhesive layer having a thickness of approximately 20 µm. More specifically, as an example, ACF 40 is preferably formed by kneading resin particles having a nickel or gold thin film (a plated film) formed on their surfaces into an adhesive layer. The diameter of the resin particles is preferably approximately 10 µm and the thickness of the adhesive layer before the resin is cured is preferably approximately 25 µm.

Casing upper-surface electrode 21 of magnetic body securing casing 20 and conductor thin film 32 of thin board 30 include a superimposing part in a planar view. ACF 40 formed as described above functions not only as an adhesive member but also as a conductive member. That is to say, the adhesive member and the conductive member are integrally configured in ACF 40. Consequently, casing upper-surface electrode 21 (first electrode) of magnetic body securing casing 20 and conductor thin film 32 (first wiring) directly overlapping casing upper-surface electrode 21 that are close to each other are electrically connected to each other by ACF 40 interposed therebetween and functioning as the adhesive member and the conductive member contacting (adhering to) both casing upper-surface electrode 21 and conductor thin film 32. In addition, ACF 40 has anisotropic conductivity.

ACF 40 extends from the region between thin board 30 and magnetic body 10 to the region between thin board 30 and magnetic body securing casing 20. Although ACF 40 is slightly smaller than thin board 30, ACF 40 has substantially the same plane area as thin board 30. ACF 40 is joined and secured to magnetic body 10 and magnetic body securing casing 20.

While ACF 40 is a film material, the anisotropic conductive material described above is not limited to ACF 40 and for example, a material such as ACP (Anisotropic Conductive Paste) that is not a film material may be used. ACP is a material in which conductive particles diffuse in an uncured resin. ACP is similar to ACF 40 in that ACP has anisotropic conductivity and may be used as an adhesive member.

Also in a case of using the ACP, thin board 30 can be joined and secured to magnetic body 10 and magnetic body securing casing 20 with sufficient strength. Moreover, instead of the anisotropic conductive material described above, a member formed by heat-pressing a gold bump or a joining layer formed by performing solid-phase diffusion joining on conductor thin film 32 of thin board 30 and opposing casing upper-surface electrode 21 of magnetic body securing casing 20 with ultrasonic joining or the like may be used.

Next, magnet 50 is arranged immediately above magnetic body 10 (on the one side of magnetic body 10, that is, a side of yoke 60). As irreversible circuit element P1 uses a direct-current magnetic field, a permanent magnet is used as magnet 50. In the present embodiment, a samarium cobalt magnet is preferably used as magnet 50. The samarium cobalt magnet has a small temperature change of coercive force and thus achieve excellent temperature characteristics. In addition, the samarium cobalt magnet has a high Curie temperature, and thus the samarium cobalt magnet can be used at a high temperature. Moreover, since the samarium cobalt magnet has excellent corrosion resistance, it is not necessary to perform a surface treatment on magnet 50.

For example, magnet 50 is formed in a cylindrical shape having a circular shape in a planar view, and preferably, the diameter of the circular shape is, for example, approximately 3.5 mm and the thickness thereof is, for example, approximately 1.2 mm. However, the appearance of magnet 50 is not limited to a cylindrical shape, and for example, magnet 50 may have a polygonal shape in a planar view.

Next, yoke 60 is arranged to control a path of magnetic lines from magnet 50. Yoke 60 is adhesion-secured to a surface on the upper side of magnet 50 by adhesive film 70. While yoke 60 preferably functions to improve magnetic characteristics required for irreversible circuit element P1 and reduce a magnetic influence exerted by a leakage flux from irreversible circuit element P1 on peripheral components, a mounter used for mounting, and the like, the function of yoke 60 is not limited thereto.

Yoke 60 is preferably composed of a material that is an iron-based material and has excellent magnetic characteristics such as magnetic permeability and residual magnetic properties. Specifically, yoke 60 is composed of pure iron, and a nickel-plated film is preferably applied on a surface of yoke 60 composed of pure iron for the purpose of rust prevention. Moreover, yoke 60 may be composed of, for example, inexpensive and easily available rolled steel for general structure (for example, SS400).

Preferably, yoke 60 has, for example, a disc shape that is circular in a planar view. Preferably, the diameter of the disc shape is, for example, 4.3 mm and the thickness thereof is, for example, 1.2 mm. However, the outer diameter shape of yoke 60 is not limited to a disc shape, and for example, yoke 60 may have a polygonal shape in a planar view or yoke 60 may cover magnet 50 from above like a cap.

Next, adhesive film 70 is sandwiched between yoke 60 and magnet 50 and between magnet 50 and thin board 30, so that these components are adhesion-secured. Magnet 50 does not need to be electrically connected to yoke 60 and to thin board 30. An insulating adhesive is thus used as adhesive film 70. Specifically, adhesive film 70 is preferably composed of, for example, a thermosetting epoxy resin adhesive, and a commercially available thermosetting epoxy resin adhesive film may be used. This commercially available thermosetting epoxy resin adhesive film is a semi-cured epoxy resin that is molded into a film in advance. Die-cutting can be performed on the semi-cured epoxy resin film and the semi-cured epoxy resin film can adhere to a peelable backing sheet. Consequently, the semi-cured epoxy resin is handled more easily than a liquid resin.

In addition thereto, adhesive film 70 may be composed of, for example, a thermoplastic resin adhesive having very large joining strength. For example, a thermoplastic film that can stand a solder reflow temperature in a mounting step of irreversible circuit element P1 on mounted part P2 may be used as the thermoplastic resin adhesive.

Adhesive film 70 is, for example, circular in a planar view. It is preferable to use adhesive film 70 having a diameter of, for example, 3.5 mm and a thickness of, for example, 0.05 mm.

Irreversible circuit element P1 constituted by the members described above is surface-mounted on mounted part P2, that is, circuit board 90 by solder balls 80. That is, solder balls 80 are arranged for the purpose of surface-mounting irreversible circuit element P1 on circuit board 90. In particular, solder balls 80 are used for surface mounting for forming a BGA (Ball Grid Array).

Solder resist SR is formed on magnetic body main surface 10B and casing main surface 20B of irreversible circuit element P1 as described above and solder balls 80 are arranged in solder resist cavities SRC, so that the BGA is formed. Solder ball 80 is preferably composed of an alloy material with a composition of, for example, Sn-3Ag-0.5Cu.

While solder ball 80 is substantially spherical, its diameter may be selected from a wide range. If the diameter of solder ball 80 is large, it is advantageous in manufacturing because steps between irreversible circuit element P1 and mounted part P2 and warps are absorbed and reduced. In addition, if the diameter of solder ball 80 is large, a large stand-off is achieved and thus it is more advantageous in reliability as compared to a case where the diameter of solder ball 80 is small. The stand-off means the vertical distance from the bottom surface of irreversible circuit element P1 to the top surface of mounted part P2. On the other hand, if the diameter of solder ball 80 is small, a pitch between solder balls 80 arranged at intervals is reduced, and thus it is advantageous in downsizing irreversible circuit device 100. In addition, if the diameter of solder ball 80 is small, it is advantageous in electrical characteristics because the distance of connection between irreversible circuit element P1 and mounted part P2 is reduced.

As described above, a trade-off is established between advantages when the diameter of solder ball 80 is large and advantages when the diameter of solder ball 80 is small. It is thus preferable to determine an optimal value of the diameter of solder ball 80 according to products that utilize irreversible circuit element P1. Basically, however, in mounting irreversible circuit element P1 described above on circuit board 90, it is preferable to use solder ball 80 having a diameter of 0.15 mm or more and 0.65 mm or less (in particular, for example, 0.5 mm).

Finally, circuit board 90 on which irreversible circuit element P1 is mounted by solder balls 80 and that is electrically connected to irreversible circuit element P1 constitutes a high-frequency circuit with magnetic body securing casing 20 described above. Circuit board 90 is arranged and secured to be joined to the lower side of solder balls 80 (the other side of solder balls 80, that is, the opposite side to magnetic body 10). In addition, circuit board 90 accommodates therein a signal processing circuit for inputting and outputting signals to and from the high-frequency circuit and an electrical circuit such as a power supply (not shown in the drawings).

Circuit board 90 is, for example, a printed board composed of a resin (a thermosetting resin) having a low dielectric loss (a thermosetting resin). Circuit board 90 may be composed of the same material as magnetic body securing casing 20.

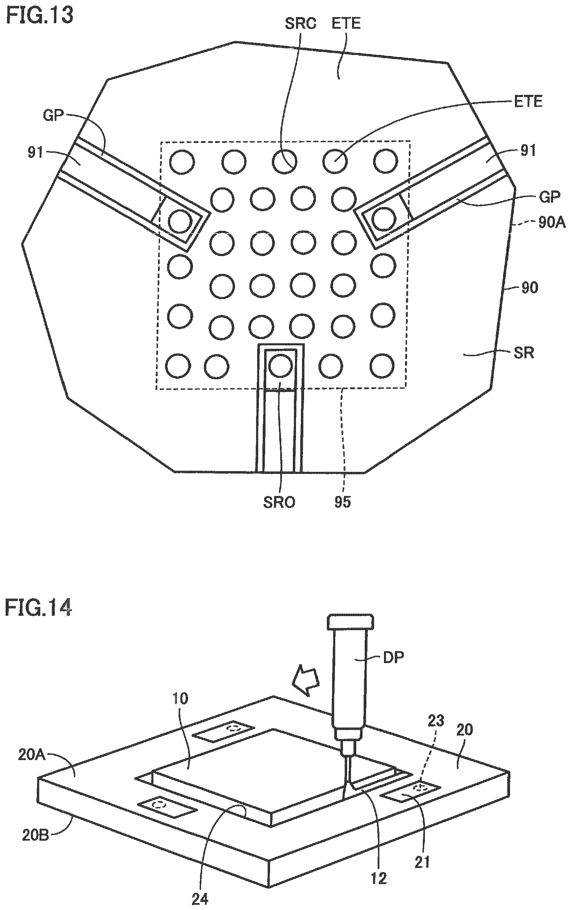

FIG. 13 shows the planar shape of circuit board 90. Referring to FIGs. 1 to 2 and 13, irreversible circuit element P1 is mounted on a circuit board main surface 90A on the upper side of circuit board 90 with solder balls 80 interposed therebetween. Solder resist SR is thus formed on circuit board main surface 90A on the upper side of circuit board 90 and solder resist cavity SRC in which solder resist SR is not arranged is formed in a region substantially overlapping a part that solder ball 80 contacts. As shown by dot lines in FIG. 13, solder resist cavity SRC is formed within an irreversible circuit element mounting region 95 substantially at the center part of circuit board 90 in a planar view.

Three circuit board conductors 91 are formed on circuit board main surface 90A. Similarly to conductor thin film 32 that is formed on thin board 30 and functions as a part of the transmission line, circuit board conductors 91 function as a part of the transmission line. The three circuit board conductors 91 are three linear transmission lines in a planar view, that extend in directions apart from each other at approximately 120° with respect to the center of the irreversible circuit element mounting region 95. At least a part of each of the three linear circuit board conductors 91 may have a partially bent region on its opposite side to the center of irreversible circuit element mounting region 95 in a planar view.

Similarly to magnetic body 10 shown in FIG. 5 and magnetic body securing casing 20 shown in FIG. 8, a thin film of a conductor material is formed on the substantially overall surface on the upper side of circuit board main surface 90A of circuit board 90. However, this thin film of the conductor material is not present in gap part GP formed in a quadrangular frame shape, and the thin film of the conductor material in a region surrounded by gap part GP is independent from the thin film of the conductor material in other regions (that may function as earth electrode ETE) as an island-like circuit board conductor 91. Solder resist SR is formed on most regions on circuit board main surface 90A to cover the thin film of a conductor material.

As shown in FIG. 13, solder resist SR is formed on only a part of the part in which circuit board conductor 91 is formed, thus forming an on-conductor solder resist SRO. In particular, within irreversible circuit element mounting region 95, solder resist cavity SRC is formed in solder resist SR on circuit board conductor 91 and other regions. In solder resist cavity SRC, a pad electrode or earth electrode ETE that is on the same layer as, for example, circuit board conductor 91 is exposed between solder ball 80 and circuit board 90, and the pad electrode or earth electrode ETE is arranged so as to contact both solder ball 80 and circuit board 90. This is because if the overall surface of circuit board conductor 91 (a transmission line) is covered by solder resist SR, a dielectric loss cannot be ignored and the function of the transmission line is degraded.

As long as an arrangement of solder resists SR achieves similar functions to those described above, the present invention is not limited to the structure shown in FIG. 13. For example, in the irreversible circuit element mounting region 95 surrounded by a dot line in the plan view of FIG. 13, (not a wiring but only) solder resist SR may be continuously connected in a planar manner. Also in this case, an aspect of the part where circuit board conductor 91 is exposed is substantially similar to that of FIG. 13.

As solder balls 80 are connected to circuit board 90 (circuit board conductor 91) as described above, casing lower-surface electrode 22 of magnetic body securing casing 20 in irreversible circuit element P1 is connected to circuit board conductor 91 that is arranged as a second wiring on circuit board 90 below magnetic body 10 (other side of magnetic body 10). In addition, rear conductor 13 on the lower side of magnetic body 10 is also connected to circuit board 90 (circuit board conductor 91) with solder balls 80 interposed therebetween, as described above. Irreversible circuit element P1 including casing lower-surface electrode 22 and rear conductor 13 is thus electrically connected to mounted part P2 including circuit board conductor 91 by a transmission line.

As rear conductor 13 formed on magnetic body main surface 10B is connected to earth electrode ETE of circuit board 90 with solder balls 80 interposed therebetween, it is possible to keep the potential of magnetic body main surface 10B equal to the potential of earth electrode ETE of circuit board 90. Irreversible circuit device 100 can thus satisfy electrical performance of a device including irreversible circuit element P1.

Circuit board conductor 91 is preferably composed of a copper thin film, and if needed, a nickel thin film having a thickness of, for example, 3 µm or more and 5 µm or less may be formed on a surface of the copper thin film and a gold thin film having a thickness of, for example, approximately 0.02 µm may be formed on a surface of the nickel thin film. These nickel and gold thin films are applied for preventing the oxidization of the copper thin film and improving solder wettability.

Moreover, circuit board 90 is preferably a plate-like member having, for example, a quadrangular (square) shape in a planar view, and preferably has a horizontal direction size of, for example, 30 mm, a vertical direction size of, for example, 30 mm, and a thickness of 0.7 mm in a planar view.

In view of the above description, according to irreversible circuit device 100 of the present embodiment, casing upper-surface electrode 21 of magnetic body securing casing 20 adheres to conductor thin film 32 of thin board 30 on the upper side of magnetic body 10, and casing lower-surface electrode 22 of magnetic body securing casing 20 is connected to circuit board conductor 91 of circuit board 90 on the lower side of magnetic body 10. Earth electrode ETE is included in the conductor of circuit board 90 to which casing lower-surface electrode 22 is connected. It is thus possible to improve characteristics of a high-frequency circuit of irreversible circuit element P1 and reliability in a connection part of solder ball 80. In magnetic body securing casing 20, casing upper-surface electrode 21 is electrically connected to casing lower-surface electrode 22 by through-conductor 23.

Irreversible circuit element P1 utilizes a unidirectional magnetic field generated by magnet 50 close to magnetic body 10 to output a high-frequency electrical signal that passes by using any of a plurality of (three) conductor terminals included in conductor thin film 32 as an input terminal from only any of other adjacent conductor terminals functioning as an output terminal. It is thus possible to supply irreversible circuit signals.

A method for manufacturing irreversible circuit device 100 according to the present embodiment is described below with reference to FIGs. 14 to 30 and, if needed, FIGs. 3 to 13.

Referring again to FIGs. 4 and 5, magnetic body 10 that is described above and shown in these drawings is prepared first. As shown in FIG. 5(B), rear conductor 13 is formed on magnetic body main surface 10B. Rear conductor 13 is a metal thin film and can be formed by a film formation process such as printing, sputtering, deposition, and plating. More preferably, rear conductor 13 is formed by plating. That is, a copper thin film having a thickness of, for example, approximately 3 µm is formed first by electroplating and a nickel thin film having a thickness of, for example, 1 µm or more and 2 µm or less is then formed on a surface of the copper thin film by plating. A gold thin film having a thickness of, for example, approximately 0.02 µm is further formed on a surface of the nickel thin film by flash plating. Rear conductor 13 may be formed on overall magnetic body main surface 10B or may be pattered to partially remain.

Next, as shown in FIGs. 5(B) and 5(C), solder resist SR for mounting solder ball 80 is laminated on the surface of rear conductor 13. Solder resist SR is then partially removed, so that solder resist cavity SRC for joining solder ball 80 is formed. As solder resist cavity SRC is formed, rear conductor 13 that underlies solder resist SR in solder resist cavity SRC is exposed as a pad electrode.

When solder resist SR is a thin film of a metal material that is not wet with solder such as chromium, solder resist SR is preferably formed by a film formation process such as sputtering and deposition. When solder resist SR is composed of an epoxy resin, solder resist SR can be formed by printing. Further, when solder resist SR is composed of a polyimide resin, solder resist SR can be formed by spin coating and then conventional photolithography.

Next, referring again to FIGs. 6 and 7, magnetic body securing casing 20 is prepared. Magnetic body securing casing 20 according to the present embodiment formed in a frame shape is machined to have, as a whole, a quadrangular shape (a square shape) in a planar view and to include a quadrangular (square) opening (securable part 24) at its center part. Securable part 24 is machined in a manner that magnetic body 10 can be fitted into securable part 24. That is, securable part 24 is preferably slightly larger than magnetic body 10 in a planar view, and preferably has a size that a gap is formed for supplying elastic adhesive 12 between an outer edge of magnetic body 10 and an inner wall surface of securable part 24

In addition, the thickness of magnetic body securing casing 20 is preferably substantially the same as that of magnetic body 10. Alternatively, there is a difference in thickness between magnetic body securing casing 20 and magnetic body 10 to an extent that does not hinder a subsequent step.

In a method for manufacturing magnetic body securing casing 20, a printed board is prepared first. Casing upper-surface electrode 21, casing lower-surface electrode 22, and through-conductor 23 that constitute a high-frequency circuit are then formed on the printed board.

A solid copper foil that is a constituent material of the printed board before machining is exposed and etched by conventional photolithography, so that casing upper-surface electrode 21 is formed on casing main surface 20A on the upper surface of the printed board. Depending on cases, casing upper-surface electrode 21 may be directly formed on a base material of the printed board by an additive process.

A solid copper foil that is a constituent material of the printed board before machining is exposed and etched by conventional photolithography, so that casing lower-surface electrode 22, earth electrode ETE, and the like are formed on casing main surface 20B on the lower side of magnetic body securing casing 20.

Next, a through-hole is formed to pass through the main body of magnetic body securing casing 20 from casing upper-surface electrode 21 on casing main surface 20A to casing lower-surface electrode 22 on casing main surface 20B. The through-hole is formed by a generally known drill or the like. After the through-hole passing through the main body of magnetic body securing casing 20 is formed by a drill or the like, a conductive metal thin film is formed on an inner wall surface of the through-hole by, for example, plating.

In this state, upper and lower surfaces of the through-hole are open and thus the through-hole is a cylindrical through-hole covered by the metal thin film. If the upper and lower surfaces remain open, however, an uncured solder resist immediately after printing and a resin of ACF 40 that melts and spreads when joined at an elevated temperature may flow into the through-hole. To prevent such a case, an opening and a through part of the through-hole may be filled with a resin or the like. The metal thin film on the inner wall surface is thus formed as through-conductor 23 that electrically connects casing upper-surface electrode 21 and casing lower-surface electrode 22 that are formed later.

Solder resist SR is also formed on casing main surface 20B of magnetic body securing casing 20 to cover casing lower-surface electrode 22, similarly to magnetic body 10. Solder resist SR is then partially removed, so that solder resist cavity SRC is formed. A specific process is basically similar to the process on magnetic body 10 described above, and thus detailed descriptions thereof are omitted.

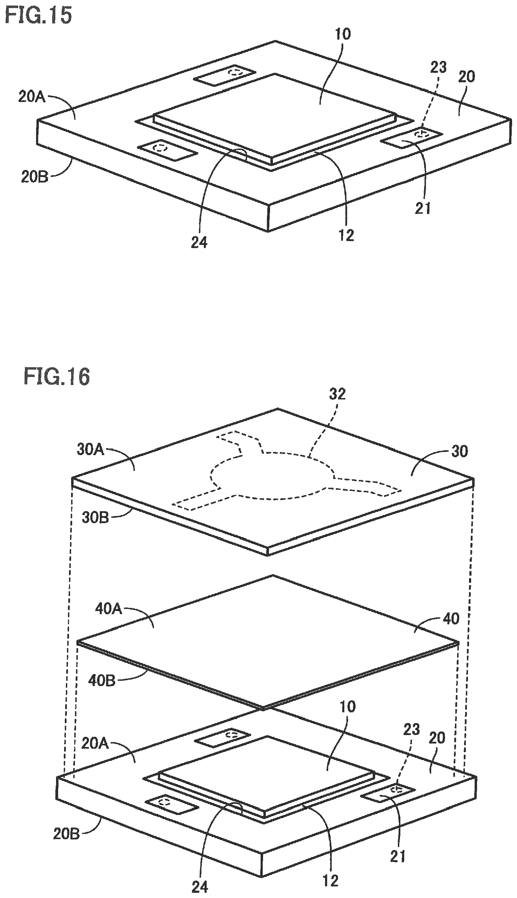

Next, magnetic body securing casing 20 is arranged to surround magnetic body 10. That is to say, as shown in FIGs. 14 and 15, this is a step of filling the gap between magnetic body 10 fitted into securable part 24 of magnetic body securing casing 20 and the inner wall surface of securable part 24 with elastic adhesive 12.

Specifically, referring to FIG. 14, magnetic body 10 is fitted into securable part 24. At this time, magnetic body 10 is fitted into securable part 24 in a manner that a surface of magnetic body 10 on which solder ball 80 is mounted faces to casing main surface 20B on the lower side of magnetic body securing casing 20.

Next, elastic adhesive 12 is supplied for filling the gap between securable part 24 of magnetic body securing casing 20 and magnetic body 10 fitted into securable part 24. Elastic adhesive 12 may be a thermosetting resin, a thermoplastic resin, or a rubber resin (an elastomer). In any case, elastic adhesive 12 is preferably liquid and is preferably composed of a material that has a cushioning function when cured. In addition, elastic adhesive 12 is preferably composed of a material that can stand a temperature in a reflow step performed at the time of surface-mounting irreversible circuit element P1 on mounted part P2.

Elastic adhesive 12 is preferably supplied by using a dispenser DP. It is thus possible to improve operational efficiency.

Referring to FIG. 15, elastic adhesive 12 supplied into securable part 24 is cured. Elastic adhesive 12 may be cured by heating or may be cured at a room temperature. In this way, magnetic body 10 is secured to magnetic body securing casing 20 and integrated therewith. In FIG. 15, magnetic body 10 is shown to be thicker than magnetic body securing casing 20 so as to be easily viewed.

Next, thin board 30 is formed, and adhesion-secured to the upper side of magnetic body 10 and the like by ACF 40. FIGs. 16 to 26 show such a step.

Thin board 30 is prepared first. Specifically, referring again to FIGs. 11, 12(A), and 12(B), a pattern of conductor thin film 32 is formed only on thin board main surface 30B on the lower side of thin board 30 (the other side of thin board 30, that is, the side on which magnetic body 10 is finally arranged), so that thin board 30 is formed.

The main body of thin board 30 with a plate shape is formed by, for example, die-cutting. It is possible to perform precise cutting without any burrs by using a dedicated die. Conductor thin film 32 may be formed by etching a copper foil bonded to a base material of thin board 30 in advance, or may be directly formed on the base material of thin board 30 by an additive process. A nickel thin film and a gold thin film may be formed on a surface of the copper foil by plating.

Next, referring to FIG. 16, for example, ACF 40 is prepared as a conductive member that has an adhesive function (is used as an adhesion member) from a region on the upper side (one side) of magnetic body securing casing 20 to a region overlapping magnetic body 10 in a planar view, and that has anisotropic conductivity. Instead of ACF 40, ACP or the like may be used as described above.

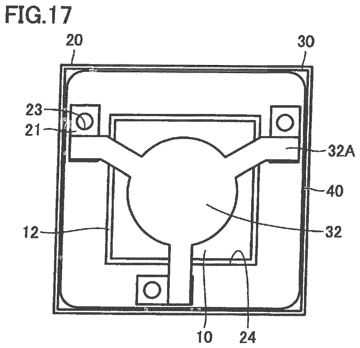

Next, referring to FIGs. 16 and 17, ACF 40 is arranged on the upper side (one side) of magnetic body securing casing 20 having magnetic body 10 secured thereto, and thin board 30 is further arranged on the upper side of ACF 40. That is to say, thin board 30 is arranged to include at least a part of the region on the upper side of magnetic body 10 and magnetic body securing casing 20. Further, that is to say, as shown in FIG. 3, thin board 30 is arranged on a region between magnet 50 to be set later and magnetic body 10 and on a region on the upper side of magnetic body securing casing 20 (a region immediately above magnetic body securing casing 20: a region overlapping magnetic body securing casing 20 in a planar view). ACF 40 is arranged to be sandwiched between thin board 30 and magnetic body 10 and magnetic body securing casing 20. That is, ACF 40 is arranged in a manner that thin board main surface 30B opposes an ACF upper-side main surface 40A and an ACF lower-side main surface 40B opposes casing main surface 20A.

As shown in the perspective view of FIG. 17, these members are arranged to substantially overlap with each other. Specifically, each of the three conductor terminals of conductor thin film 32, casing upper-surface electrode 21, and casing lower-surface electrode 22 are arranged to overlap with each other. In this case, it is preferable to arrange these members in a manner that through-conductor 23 of magnetic body securing casing 20 does not overlap a distal end part 32A of a linearly extending conductor terminal of conductor thin film 32 on thin board 30 and distal end part 32A of the conductor terminal overlaps casing upper-surface electrode 21 (and casing lower-surface electrode 22). While through-conductor 23 does not overlap distal end part 32A in FIG. 17, it may be configured in the present embodiment in a manner that through-conductor 23 overlaps distal end part 32A. Such an arrangement enables casing upper-surface electrode 21, through-conductor 23, and casing lower-surface electrode 22 to be electrically connected with each other. With such electrical connection, a unit of casing upper-surface electrode 21, casing lower-surface electrode 22, and through-conductor 23 is electrically connected to each of the three conductor terminals of conductor thin film 32.

That is, when thin board 30, ACF 40, and magnetic body securing casing 20 are finally joined and secured, conductor thin film 32 contacts ACF upper-side main surface 40A and casing upper-surface electrode 21 contacts ACF lower-side main surface 40B. A conduction function of ACF 40 thus enables conductor thin film 32 (each of three conductor terminals respectively including distal end parts 32A) and the unit of casing upper-surface electrode 21, casing lower-surface electrode 22, and through-conductor 23 that are overlapped with each other to be electrically connected to each other.

To achieve such electrical connection, it is necessary to precisely position conductor thin film 32 and casing upper-surface electrode 21 for the purpose of preventing mispositioning. As conductor thin film 32 is superimposed on casing upper-surface electrode 21 in a manner that distal end part 32A is overlapped with casing upper-surface electrode 21 (the region that does not overlap with through-conductor 23), it is possible to easily position thin board 30 and magnetic body securing casing 20, and conductor thin film 32 is easily electrically connected to casing upper-surface electrode 21. If thin board 30 is spaced apart from magnetic body securing casing 20 in a planar view and a trench or the like is present between thin board 30 and magnetic body securing casing 20, it is necessary to have a conductor (a wire bond, a ribbon bond, or the like) for bridging and electrically connecting conductor thin film 32 and casing upper-surface electrode 21. In the present embodiment, however, conductors of thin board 30 and magnetic body securing casing 20 (conductor thin film 32 and casing upper-surface electrode 21) are overlapped with each other and thus these conductors can be easily electrically connected to each other with ACF 40 interposed therebetween.

As shown in FIG. 16, the size of thin board 30 in a planar view is preferably slightly smaller than the size of magnetic body securing casing 20 and the size of ACF 40 in a planar view is preferably slightly smaller than the size of thin board 30. The sizes of thin board 30 and ACF 40 are adjusted as described above because ACF 40 melts and spreads by subsequent heating and pressing steps. If ACF 40 leaks from outer edges of thin board 30 and magnetic body securing casing 20, a failure may occur, that is, the distance between irreversible circuit element P1 and other electronic components mounted to be adjacent to irreversible circuit element P1 is significantly reduced and thus a short-circuit may occur between irreversible circuit element P1 and the other electronic components. In addition, when a bonder or the like handles a constituent member of irreversible circuit element P1 or the like in a step of mounting irreversible circuit element P1 on a surface of mounted part P2 prior to a reflow step, extending ACF 40 may be an obstacle. In view of preventing such a failure, it is preferable to prevent the leakage of ACF 40 and thus the size is adjusted as described above. As shown in FIG. 17, after these members are bonded, and adhesion-secured, ACF 40 spreads from its original size, and thus the plane area thereof is slightly increased.

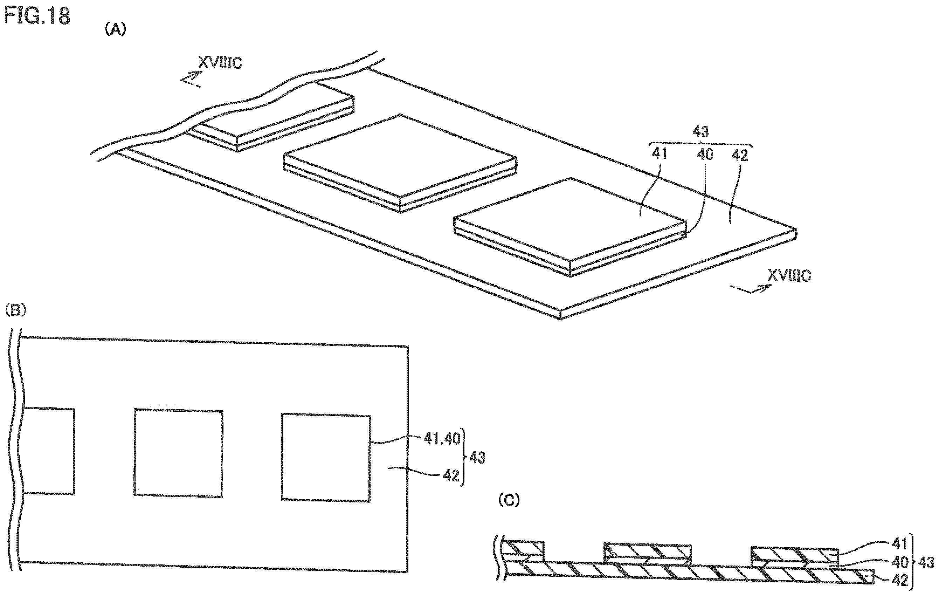

FIGs. 16 and 17 show only the positional relationship between ACF 40 and other members and in practice, ACF 40 supplied in the present step has a different aspect from the aspect described above. This is described below with reference to FIGs. 18(A), 18(B), and 18(C).

Referring to FIGs. 18(A), 18(B), and 18(C), ACF 40 used in the present step is originally configured to be sandwiched between separators respectively bonded to the upper-side and lower-side main surfaces of ACF 40. A heavy separator 41 that has substantially the same size as ACF 40 in a planar view is bonded to the upper-side main surface of ACF 40. A light separator 42 that has a larger size than ACF 40 in a planar view is bonded to the lower-side main surface of ACF 40. That is, ACF 40 is arranged as a part of a three-layer film 43 that has a three-layer structure in which light separator 42, ACF 40, and heavy separator 41 are laminated in this order.

Heavy separator 41 means a separator that has heavy peeling force from ACF 40 (that has high adhesive strength and is hardly peeled). Heavy separator 41 has substantially the same horizontal direction and vertical direction sizes as ACF 40 in a planar view, that are, for example, 6.6 mm and a thickness of, for example 50 µm (ACF 40 has a thickness of, for example, 25 µm). On the other hand, light separator 42 means a separator that has light peeling force from ACF 40 (that has low adhesive strength and is easily peeled). Light separator 42 extends in a direction in which heavy separators 41 and ACFs 40 are arranged at intervals, and is bonded to overlap all these separators 41 and ACFs 40. Consequently, light separator 42 has larger horizontal direction and vertical direction sizes than ACF 40 in a planar view.

A base formed by bonding ACF 40 and heavy separator 41 is die-cut into a plurality of quadrangular pieces in advance. These quadrangular pieces are bonded to a surface of a film of elongated light separator 42 to be arranged thereon at intervals. Three-layer film 43 formed as described above is wound around a reel and then shipped.

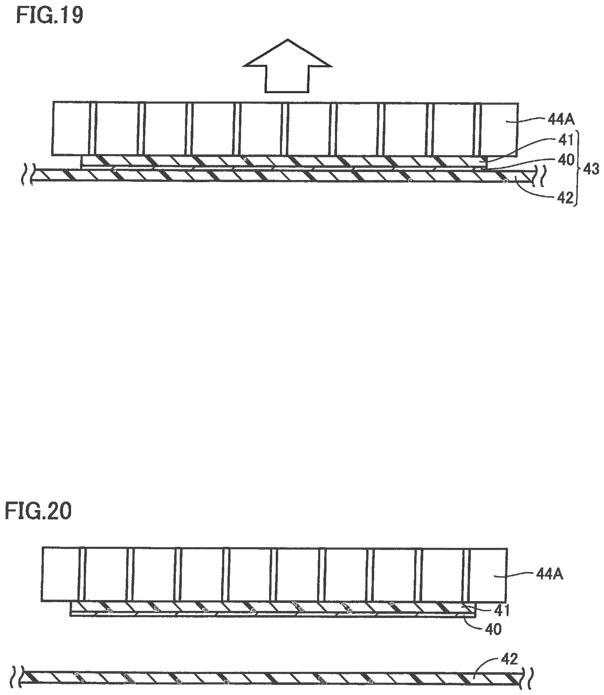

When thin board 30 is bonded to magnetic body securing casing 20 using three-layer film 43 with the configuration described above, ACF 40 temporarily adheres first to magnetic body securing casing 20 and magnetic body 10, and magnetic body securing casing 20 and magnetic body 10 having ACF 40 temporarily adhered thereto then permanently adhere to thin board 30. Casing upper-surface electrode 21 of magnetic body securing casing 20 is thus connected to conductor thin film 32 (first wiring) of thin board 30 arranged on the upper side of magnetic body 10. This bonding step is described below with reference to FIGs. 19 to 26.

Referring to FIG. 19, in the bonding step, a bonder that can simultaneously perform heating and pressing is used. Specifically, a bonder that includes a bonder head 44A shown in FIG. 19, a heating stage to be described later (not shown in FIG. 19), and a positioning camera to be described later (not shown in FIG. 19) is used.

For example, bonder head 44A has a function of vacuum-sucking three-layer film 43 and a function of heating and pressing vacuum-sucked three-layer film 43. In addition, in view of terminating a step of curing ACF 40 under pressure in a short time, it is preferable to use bonder head 44A that includes a heater tool that can perform heat curing and cooling in a short time. Specifically, bonder head 44A preferably uses a ceramic heater or a pulse heater.

A surface of bonder head 44A on its lower side approaches three-layer film 43 drawn from a reel from above and vacuum-sucks heavy separator 41 arranged on the top layer of three-layer film 43. Under such a state, bonder head 44A is moved upward as shown by an arrow in FIG. 19.

Referring to FIG. 20, when bonder head 44A is moved upward, light separator 42 is separated from three-layer film 43. Bonder head 44A thus vacuum-sucks only a piece of laminated heavy separator 41 and ACF 40.

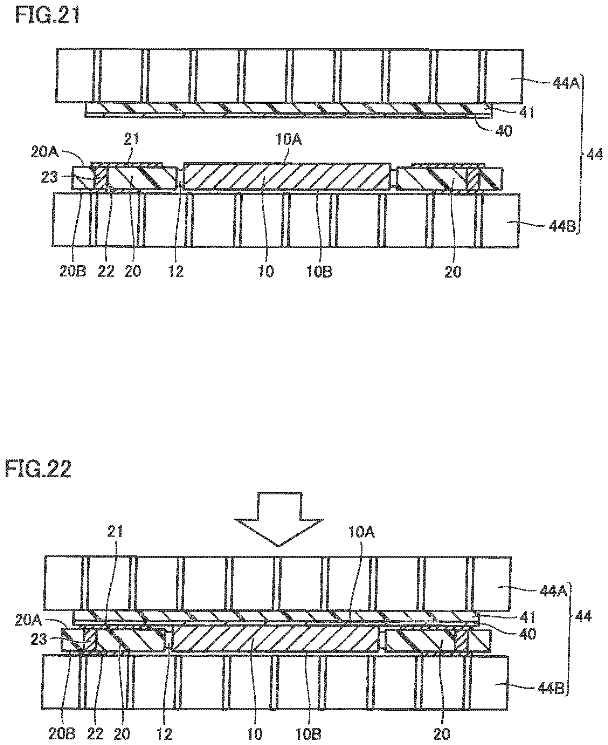

Referring to FIG. 21, magnetic body securing casing 20 having magnetic body 10 secured thereto by elastic adhesive 12 is placed on heating stage 44B that constitutes bonder 44 with bonder head 44A and vacuum-sucked. Immediately above, positioning is then performed by using a positioning camera (not shown) that constitutes bonder 44 in a manner that a piece of heavy separator 41 and ACF 40 having been vacuum-sucked to bonder head 44A in the step of FIG. 20 overlaps magnetic body securing casing 20. At this time, heavy separator 41 and the like are arranged to be spaced apart from magnetic body 10 and the like in the up-down direction.

Referring to FIG. 22, after the positioning described above, bonder head 44A is moved downward in a direction shown by an arrow, and thus ACF 40 and heavy separator 41 are pressed on magnetic body 10 and magnetic body securing casing 20 with predetermined pressure. ACF 40 is adhesive even at a room temperature and thus temporarily adheres to magnetic body 10 and magnetic body securing casing 20. In this step, if the temperature of bonder head 44A is increased and kept at, for example, 80°C, and then bonder head 44A performs downward pressing at a pressing force of 1 MPa and a pressing time of 2 seconds, it is possible to perform more reliable temporary adhesion. More preferably, bonder head 44A simultaneously performs heating and pressing, as described above.

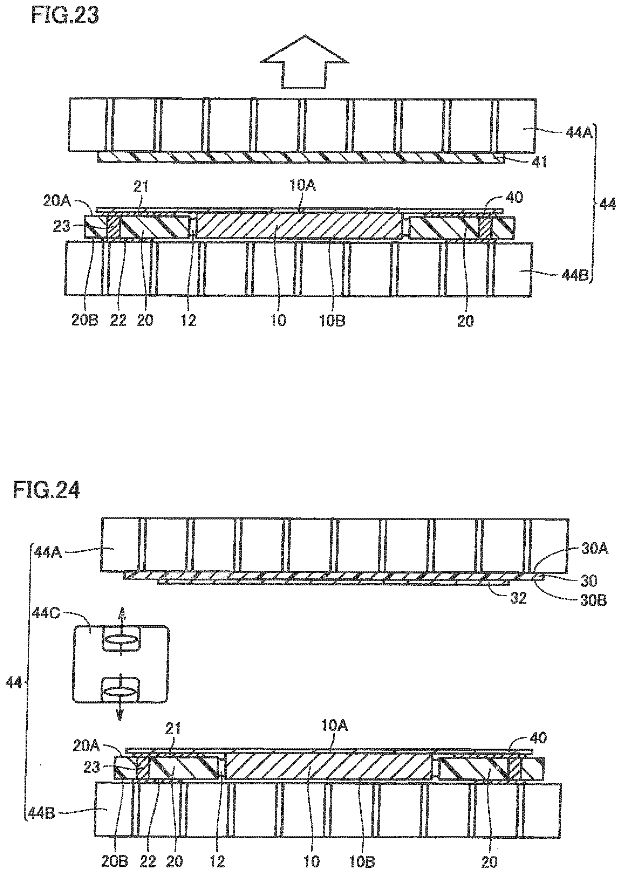

Referring to FIG. 23, after ACF 40 temporarily adheres to magnetic body 10 and the like, bonder head 44A is moved upward as shown by an arrow while ACF 40 and the like are still vacuum-sucked. Heavy separator 41 that is vacuum-sucked to bonder head 44A is thus peeled from ACF 40 and moved upward with bonder head 44A. Heavy separator 41 is then removed from bonder head 44A and discarded.

As ACF 40 temporarily adheres to magnetic body 10 and the like as described above, it is possible to prevent a failure, that is, to prevent ACF 40 from positionally shifting from the surface of magnetic body 10 and the like or from being peeled therefrom and falling by possible vibrations in subsequent steps.

In temporary adhesion, the temperature and load are lower and the time is shorter than those of permanent adhesion to be described later. Consequently, the temporary adhesion reduces the possibility that ACF 40 may flow or deform. The outline sizes of the members hardly change before and after the temporary adhesion.

Next, referring to FIG. 24, thin board 30 that is die-cut and includes conductor thin film 32 thereon is vacuum-sucked to the lower surface of bonder head 44A. Thin board 30 is fed on the lower surface of bonder head 44A by arranging thin board 30 on a dedicated tray or supplying thin board 30 from a reel. Bonder head 44A having thin board 30 sucked thereto is transported immediately above heating stage 44B.

Thin board 30 is sucked to bonder head 44A in a manner that thin board main surface 30A contacts bonder head 44A to be sucked thereto and thin board main surface 30B having conductor thin film 32 formed thereon faces downward and opposes ACF 40.

Next, thin board 30 vacuum-sucked to bonder head 44A is positioned with respect to magnetic body securing casing 20, magnetic body 10, and ACF 40 that are vacuum-sucked to heating stage 44B.

The positioning is performed by a positioning camera 44C that constitutes bonder 44. The positioning is performed by positioning camera 44C as follows. That is, a part that requires electrical connection, that is, the shape of casing upper-surface electrode 21 and distal end part 32A of conductor thin film 32 in a planar view is used and positions of these members are overlapped with each other (see FIG. 17). ACF 40 is semi-transparent and thus it is easy to check the position of casing upper-surface electrode 21 temporarily adhering to the underside of ACF 40 by using a planar view from above. If needed, a dedicated positioning mark may be given to magnetic body securing casing 20 and thin board 30 and positioning may be performed by secondarily using these marks.

When the position of the outer edge of ACF 40 is slightly shifted from the position of the outer edge of magnetic body 10, the position of magnetic body 10 (an X horizontal shift, a Y vertical shift, and a θ rotational shift) may be adjusted if needed based on a positioning algorithm so as to minimize an image shift amount.

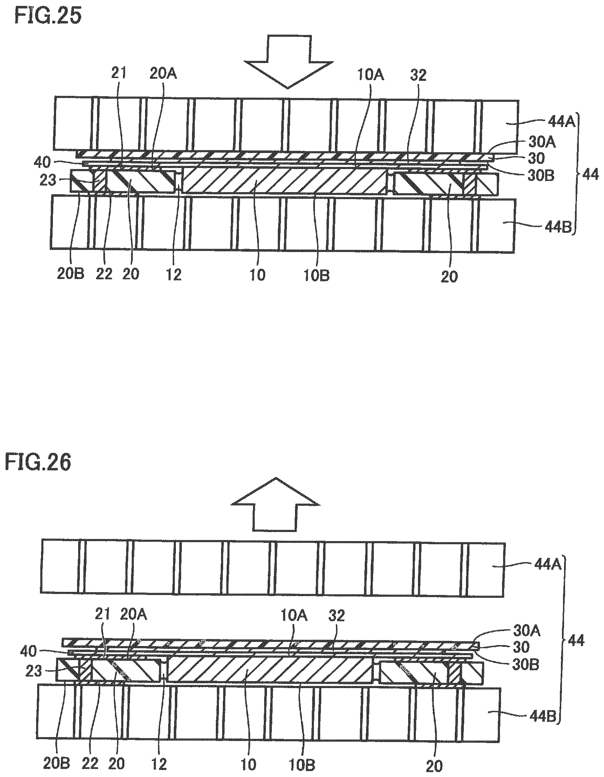

Referring to FIG. 25, after the thin board 30 is positioned with respect to ACF 40 and the like by using positioning camera 44C and the like in the step of FIG. 24, bonder head 44A is moved downward as shown by an arrow. Magnetic body 10 having ACF 40 temporarily adhering thereto and the like thus overlaps thin board 30 to contact thin board 30. Heated bonder head 44A is pressed downward as in the step of FIG. 22. ACF 40 sandwiched between thin board 30 and magnetic body 10 and magnetic body securing casing 20 is thus heated, pressed, and cured. In this way, magnetic body securing casing 20 having magnetic body 10 secured thereto, ACF 40, and thin board 30 are adhesion-secured, and casing upper-surface electrode 21 is electrically connected to conductor thin film 32.

In this step, for example, the heating temperature of bonder head 44A is 180°C, the downward pressing force of bonder head 44A is 3 MPa, and the pressing time of bonder head 44A is 10 seconds.

Referring to FIG. 26, after magnetic body securing casing 20 having magnetic body 10 secured thereto, ACF 40, and thin board 30 are made to permanently adhere in the step of FIG. 25, bonder head 44A is moved upward as shown by an arrow to be apart from thin board 30. With the permanent adhesion, magnetic body securing casing 20 having magnetic body 10 secured thereto strongly adheres to thin board 30 by ACF 40 interposed between magnetic body securing casing 20 and thin board 30. In addition, conductor thin film 32 is reliably electrically connected to casing upper-surface electrode 21.

As described above, a part of conductor thin film 32 of thin board 30 adheres to a part of casing upper-surface electrode 21 of magnetic body securing casing 20 by heating and pressing using ACF 40. In this way, by using the adhesive function of ACF 40 functioning as a conductive member having anisotropic conductivity from the region on the upper side of magnetic body securing casing 20 outside magnetic body 10 to the region overlapping magnetic body 10 in a planar view, thin board 30 (conductor thin film 32) and magnetic body securing casing 20 (casing upper-surface electrode 21) having magnetic body 10 secured thereto are adhesion-secured to be electrically connected to each other.

Next, referring again to FIG. 3, magnet 50 and yoke 60 are prepared and magnet 50 adheres to yoke 60 by adhesive film 70. Specifically, magnet 50 is prepared first and adhesive film 70 is then supplied to be superimposed on magnet 50. Yoke 60 is then arranged to be superimposed on adhesive film 70. Heating and pressing are performed on magnet 50, yoke 60, and adhesive film 70, so that magnet 50 adheres to yoke 60.

In the adhesion step described above, heating and pressing may be performed by bonder 44 shown in FIGs. 19 to 26. Alternatively, in the adhesion step described above, a jig (not shown) that includes a spring mechanism that can apply desired pressure may be used and a process may be performed in a heating and drying furnace.

Next, referring again to FIG. 3, magnet 50 and yoke 60 adhering to each other adhere to thin board main surface 30A (the opposite side to magnetic body 10) on the upper side of thin board 30 that has been secured to magnetic body 10 and the like by ACF 40. Magnet 50 for enabling irreversible circuit element P1 to function is thus arranged on magnetic body 10.

It is ideal for magnet 50 to be arranged in a manner that the geometric center of a circular center conductor in the center part of thin board 30 (a part of conductor thin film 32) matches the geometric center of magnet 50. As a result of fine positional adjustments in view of variations in the magnetic force of magnet 50 and the like, however, there may be a little positional shift between the center conductor and magnet 50 in manufacturing products.

Similarly to the adhesion step of magnet 50 and yoke 60 described above, for example, adhesive film 70 is arranged between magnet 50 and thin board 30 (thin board main surface 30A immediately above the region overlapping the center conductor), and is adhesion-secured by heating and pressing.

Instead of adhesive film 70 described above, an insulating adhesive composed of liquid or a viscous material may be supplied to thin board main surface 30A and magnet 50 by using a generally known transfer process or dispenser DP (see FIG. 14).

The main part of irreversible circuit element P1 is thus completed. Next, referring to FIGs. 2 and 3, solder ball 80 is mounted for surface-mounting completed irreversible circuit element P1 on mounted part P2 so as to form BGA.

For example, referring again to FIG. 10(B), solder balls 80 are arranged in (mounted on) and secured to solder resist cavities SRC on casing main surface 20B on the lower side of magnetic body securing casing 20 and on magnetic body main surface 10B on the lower side of magnetic body 10 in irreversible circuit element P1, thus being mounted on irreversible circuit element P1.

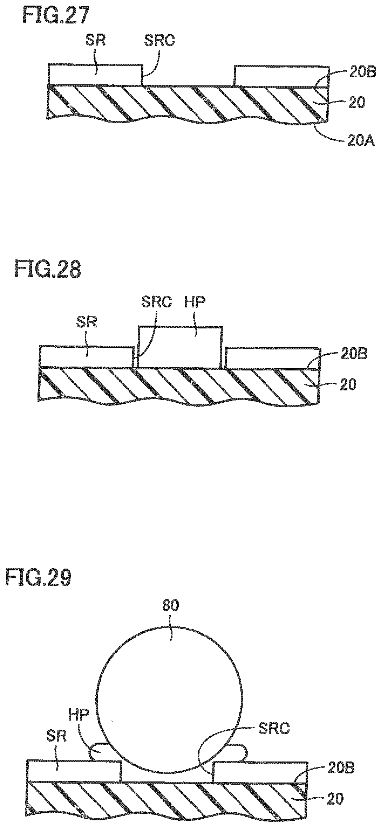

That is, solder balls 80 are basically arranged in a matrix on overall magnetic body 10 in a planar view at intervals. In addition, solder balls 80 are arranged on the overall region extending vertically and horizontally on magnetic body securing casing 20 in a planar view at intervals. In FIG. 3, while solder balls 80 are shown to be arranged only on the front side of the drawing, this is only for easy understanding of the drawing and in practice, solder ball 80 are also arranged on the back side of the drawing. This step is described below with reference to FIGs. 27 to 30.

Referring to 27, firstly, irreversible circuit element P1 is accommodated upside down in a jig (not shown) in a manner that casing main surface 20B and magnetic body main surface 10B originally facing downward face upward. As described above, solder resist SR and solder resist cavity SRC have been formed on casing main surface 20B and magnetic body main surface 10B.

Projection members including magnet 50 and yoke 60 are included in an upper part of irreversible circuit element P1. In view of these projection members being arranged in a lower part of irreversible circuit element P1 when irreversible circuit element P1 is turned upside down, the jig that accommodates therein the upside down irreversible circuit element P1 preferably includes a recess that can accommodate therein the projection member or the like. In addition, irreversible circuit element P1 includes magnet 50, and thus the jig is preferably composed of a metal material or a resin material that is a non-magnetic body.

Magnetic body securing casing 20 and the like are secured to the jig in a manner that the position (the height) of solder resist cavity SRC formed on casing main surface 20B is substantially the same as the position of the jig in the up-down direction.

Referring to FIG. 28, under such a state, a solder paste HP is supplied to each of solder resist cavities SRC by, for example, screen printing. Although not shown in FIG. 28, casing lower-surface electrode 22, other wirings, or the like is basically exposed in solder resist cavity SRC. Solder paste HP is printed and supplied to contact (cover) the exposed electrode, the exposed wirings, or the like. Alternatively, only a flux may be supplied to solder resist cavity SRC by screen printing.

Referring to FIG. 29, solder ball 80 is supplied to each of solder resist cavities SRC having solder past HP or a flux supplied thereto in the step of FIG. 28 by a solder ball mounting device (not shown). Supplied solder ball 80 is temporarily secured to casing main surface 20B by the adhesive force of solder paste HP or the flux. If needed, pressing force may be applied to solder ball 80 from above in FIG. 29 and such pressing enables more reliable temporary securing. As shown in FIG. 29, a part of solder paste HP is pressed by solder ball 80 that applies force downward in FIG. 29 by its own weight or the pressing force, thus sometimes extending outside solder resist cavity SRC.

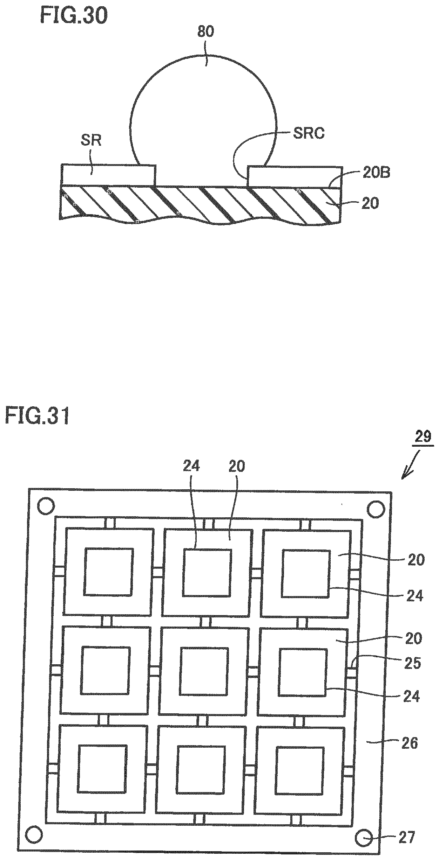

Referring to FIG. 30, irreversible circuit element P1 having solder balls 80 described above supplied thereto is held by a thermal-resistance jig (not shown) that can hold irreversible circuit element P1 upside down as in FIGs. 27 to 29. Under such a state, irreversible circuit element P1 is put into a reflow furnace to pass through a high-temperature environment in the reflow furnace. Solder ball 80 and solder paste HP are melted in a mixed manner and after passing through the high-temperature environment in the reflow furnace, solder ball 80 and solder paste HP are cooled and solidified. Casing main surface 20B of magnetic body securing casing 20 (an electrode, a wiring, or the like in solder resist cavity SRC) is thus joined and secured to solder ball 80 in an integrated manner. After the step of passing through the reflow furnace, solder ball 80 is integrated with solder paste HP and thus cannot be distinguished therefrom.

Next, a flux residue adhering to or remaining on a surface of solder ball 80 and a surface of a part of constituent members of irreversible circuit element P1 is removed by washing. However, if it has been found that the amount of the residue is so small that it does not affect the electrical characteristics and reliability of irreversible circuit device 100 that is a final product, the step of washing and removing may be omitted. In this way, solder ball 80 is adhesion-secured to irreversible circuit element P1.

While FIGs. 27 to 30 show only the adhering and securing step of solder ball 80 to solder resist cavity SRC formed in magnetic body securing casing 20, solder ball 80 is also adhesion-secured to solder resist cavity SRC formed on magnetic body 10 by the similar step. The process of securing solder ball 80 to magnetic body securing casing 20 is basically the same as the process of securing solder ball 80 to magnetic body 10 and these processes are basically performed simultaneously. For this reason, detailed descriptions of the adhesion step of solder ball 80 to solder resist cavity SRC of magnetic body 10 are omitted.

Next, referring to FIG. 2, circuit board 90 functioning as mounted part P2 is joined to the lower side of solder balls 80 adhesion-secured to irreversible circuit element P1. Irreversible circuit element P1 is thus surface-mounted on circuit board 90 functioning as mounted part P2. In addition, casing lower-surface electrode 22 of magnetic body securing casing 20 is connected to circuit board conductor 91 and earth electrode ETE (second wiring) of circuit board 90 arranged below magnetic body 10.

Specifically, referring again to FIG. 13, circuit board 90 is prepared first in which solder resist SR, solder resist cavity SRC, and the like have been formed on circuit board main surface 90A on the upper side of circuit board 90 (on circuit board conductor 91, earth electrode ETE, and the like). The method for forming solder resist SR and the like is similar to the method for forming solder resist SR on magnetic body 10 or magnetic body securing casing 20, and thus descriptions thereof are omitted.

Basically, similarly to the step of FIG. 28, solder paste HP is supplied to each of solder resist cavities SRC by, for example, screen printing. Circuit board conductor 91, earth electrode ETE, or the like is basically exposed in solder resist cavity SRC. Solder paste HP is printed and supplied to contact (cover) the exposed conductor, the exposed electrode, or the like. Alternatively, only a flux may be supplied into solder resist cavity SRC by screen printing.

Next, basically similarly to the step of FIG. 29, solder ball 80 is supplied to each of solder resist cavities SRC having solder past HP or a flux supplied thereto.

Next, basically similarly to the step of FIG. 30, circuit board 90 having irreversible circuit element P1 and other electronic components (not shown) mounted thereon is put into a reflow furnace to pass through a high-temperature environment in the reflow furnace. As described above, solder ball 80 is thus jointed to the conductor of circuit board 90 and the like. As described above, the step of washing and removing a flux residue, which is a post step, may be omitted in some cases.

In this way, irreversible circuit device 100 according to the present embodiment (see FIG. 2) is formed.

Next, an operation and effect of the present embodiment are described while the background in which the present embodiment is conceived and problems are also described.

In the present embodiment, through-conductor 23 is formed in magnetic body securing casing 20 instead of magnetic body 10. Through-conductor 23 enables conductor thin film 32 (first wiring) on the upper side of (one side) magnetic body 10 to be electrically connected to circuit board conductor 91 (second wiring) on the lower side (other side) of magnetic body 10. In addition, these members form a transmission line. Consequently, it is not necessary to form a through-hole so as to pass through magnetic body 10. In addition, it is not necessary to form a conductor material that connects the first wiring to the second wiring so as to cover the outer surface of magnetic body 10.

When a through-hole is formed in magnetic body 10 such as ferrite, microcracks or chipping may locally occur in magnetic body 10 due to the hardness of magnetic body 10, thus leading to product defects such as larger breaking and chipping. As a result, the product yield may be decreased. In addition, magnetic body 10 is hard and thus it is difficult to form a through-hole. Consequently, it is necessary to perform laser machining and sand blast machining to form a through-hole in magnetic body 10, resulting in extremely high machining costs.

The step of forming a conductor material having equivalent function to through-conductor 23 for connecting a wiring above magnetic body 10 to a wiring below magnetic body 10 on a surface of magnetic body 10 such as an upper surface, a lower surface, and a side surface requires a process of dividing a through-conductor into, for example, two pieces so as to have a cross-section along a direction in which the through-conductor extends. Such machining is very difficult and a failure may occur, that is, a conductor material on the cross-section may be peeled. It is possible to form the conductor material having equivalent function to through-conductor 23 for connecting a wiring above magnetic body 10 to a wiring below magnetic body 10 on a surface of magnetic body 10 such as an upper surface, a lower surface, and a side surface by attaching bent metal to the surface. This step also requires a very difficult process.

If the method for forming a through-hole and through-conductor 23 in magnetic body securing casing 20 composed of a resin material is employed as in the present embodiment, the through-hole and through-conductor 23 therein can be formed in the same step as in a printed board or a multi-layer ceramic board that is generally mass-produced, and thus machining becomes easy. It is not necessary to perform the step of forming a conductor material that covers a through-hole or the outer surface in magnetic body 10, and thus it is possible to prevent microcracks or chipping described above, thus significantly reducing manufacturing costs.

A through-hole is not formed in magnetic body 10 composed of ferrite or the like in the present embodiment, and thus it is easy to attach a plated film such as a copper plated film functioning as through-conductor 23 to the inner wall surface of the through-hole. That is, a plated film in the through-hole formed in ferrite has lower adhesive force to the inner wall surface of the through-hole and thus is easily peeled. Meanwhile, the step of forming a plated film in the through-hole of magnetic body securing casing 20 is the same as in a printed board or a multi-layer ceramic board that is generally mass-produced and thus machining is easy.

In the present embodiment, casing upper-surface electrode 21 and casing lower-surface electrode 22 are formed on magnetic body securing casing 20 instead of magnetic body 10 and these casing upper-surface electrode 21 and casing lower-surface electrode 22 constitute a high-frequency circuit and a transmission line for irreversible circuit element P1. It is thus unnecessary to directly form a conductor such as an electrode on surfaces of magnetic body 10 including the upper and lower surfaces of magnetic body 10.

In the step of directly forming a conductor material on a surface of magnetic body 10 such as an upper surface and a lower surface, for example, a metalizing step and an etching step are more difficult than usual and machining costs are significantly expensive. Also in this machining (as in machining magnetic body 10 to form a through-hole therein), microcracks or chipping may locally occur in magnetic body 10, thus leading to product defects such as larger breaking and chipping. As a result, the product yield may be decreased.

If the method for forming casing upper-surface electrode 21 and casing lower-surface electrode 22 on magnetic body securing casing 20 composed of a resin material is employed as in the present embodiment, however, a through-hole and through-conductor 23 can be formed in the same step as in a printed board or a multi-layer ceramic board that is generally mass-produced, and thus machining becomes easy. It is not necessary to perform the step of directly forming a conductor such as an electrode on a surface of magnetic body 10 such as an upper surface and a lower surface, and thus it is possible to prevent microcracks or chipping described above and machining becomes easy, thus significantly reducing manufacturing costs.

In addition, according to the present embodiment, a through-hole is not formed in magnetic body 10 and thus the outline size of magnetic body 10 can be reduced accordingly. A material constituting magnetic body 10 such as ferrite is expensive and the reduction in size leads to a reduction in manufacturing costs.

As the size of magnetic body 10 is reduced and a high-frequency circuit is formed not in magnetic body 10 but in magnetic body securing casing 20, it is possible to minimize the influence of the difference between linear expansion coefficients of the members that is problematic in using surface-mounting irreversible circuit device 100. This is achieved by reducing the size of magnetic body 10 having a large difference of linear expansion coefficient between magnetic body 10 and circuit board 90 and by using magnetic body securing casing 20 composed of a material that is the same as or similar to that of circuit board 90. It is thus possible to reduce the possibility of damages caused by large thermal stress, thus improving reliability.

In the present embodiment, magnetic body 10 is arranged substantially in the center part in a planar view and frame-like magnetic body securing casing 20 is arranged so as to surround magnetic body 10. In such a case, on a plane constituted by magnetic body 10 and magnetic body securing casing 20, the thermal stress is generally increased as being apart from the center part on which magnetic body 10 is arranged toward outside. In the present embodiment, however, magnetic body 10 having a large difference of linear expansion coefficient between magnetic body 10 and circuit board 90 on which irreversible circuit element P1 is mounted is arranged in the center part, and magnetic body securing casing 20 having a substantially same linear expansion coefficient as circuit board 90 is arranged outside magnetic body 10. Consequently, it is possible to reduce the thermal stress in the present embodiment as compared to a case where such a configuration is not provided and to improve reliability.

As described above, it is possible to achieve irreversible circuit element P1 according to the present embodiment in which casing upper-surface electrode 21, casing lower-surface electrode 22, and through-conductor 23 are formed on magnetic body securing casing 20, casing upper-surface electrode 21 is connected to conductor thin film 32b above magnetic body 10, and casing lower-surface electrode 22 is connected to circuit board conductor 91 below magnetic body 10. Manufacturing costs and manufacturing defects of irreversible circuit element P1 are reduced, reliability is improved, and machining becomes easy.

Next, in the present embodiment, thin board 30 is provided in the region between magnet 50 and magnetic body 10. Thin board 30 can thus be substituted for a dielectric component that is conventionally provided as a member (a spacer) different from a member for forming a wiring like thin board 30 between magnet 50 and magnetic body 10. That is, in the present embodiment, thin board 30 is arranged as a member for forming a first wiring on the upper side of magnetic body 10 and at the same time, is arranged to function as a dielectric material having a low dielectric loss that corresponds to the spacer.

Magnet 50 is arranged immediately on thin board 30 and thus it is not necessary to additionally arrange a member corresponding to a spacer. This is because a dielectric material constituting thin board 30 constitutes a part of a transmission line as described above, and the dielectric material also has a function of preventing an electromagnetic field generated by signals passing through a high-frequency circuit from leaking to the side of magnet 50. This function is originally included in the spacer, and thus thin board 30 can function as a member substituted for the spacer. It is thus possible to reduce the number of members constituting irreversible circuit element P1 and to simplify the configuration of irreversible circuit element P1.

Thin board 30 is arranged not only on the region between magnet 50 and magnetic body 10 but on the region on the upper side of magnetic body securing casing 20. That is to say, thin board 30 is arranged so as to include the regions on the upper side of magnetic body 10 and on the upper side of magnetic body securing casing 20. In particular, regarding thin board 30 arranged immediately on magnetic body securing casing 20, conductor thin film 32 is formed only on thin board main surface 30B on the lower side of thin board 30, and thus casing upper-surface electrode 21 constituting a high-frequency circuit can be electrically easily connected to conductor thin film 32. It is only required that conductor thin film 32 be formed only on a main surface on the side on which magnetic body 10 is arranged, that is, thin board main surface 30B, and conductor thin film 32 does not need to be formed on thin board main surface 30A. It is thus possible to simplify the configuration of a device and reduce manufacturing costs as compared to a case where a conductor thin film needs to be formed on both main surfaces 30A and 30B of thin board 30.

Next, in the present embodiment, thin board 30 closely contacts magnetic body 10 with high strength by ACF 40 functioning as an adhesive member arranged between thin board 30 and magnetic body 10. ACF 40 extends from the region between thin board 30 and magnetic body 10 to the region between thin board 30 and magnetic body securing casing 20, and thus substantially overall thin board 30 can be adhesion-secured to magnetic body 10 and the like by ACF 40.

In addition, ACF 40 has anisotropic conductivity and is arranged between casing upper-surface electrode 21 of magnetic body securing casing 20 and conductor thin film 32 of thin board 30 in a superimposed part of casing upper-surface electrode 21 and conductor thin film 32. Therefore, for example, as shown in FIGs. 16 and 17, positioning is performed in a manner that conductor thin film 32 is superimposed on casing upper-surface electrode 21, ACF 40 is then sandwiched between conductor thin film 32 and casing upper-surface electrode 21, and conductor thin film 32 closely contacts casing upper-surface electrode 21 with ACF 40 interposed therebetween. It is thus possible to simultaneously achieve joining and securing of magnetic body securing casing 20 and thin board 30, and electrical connection of magnetic body securing casing 20 and thin board 30.

As ACF 40 has not only an adhesive property but also a conductive property, conductor thin film 32 is electrically connected to casing upper-surface electrode 21. It is thus unnecessary to form a conductor material that is conventionally required to electrically connect conductor thin film 32 to casing upper-surface electrode 21. As a result, it is possible to further simplify the configuration of a device and steps.

In addition, ACF 40 has anisotropic conductivity. That is to say, ACF 40 has a characteristic that only the part where conductive particles are captured is conductive. For this reason, if electrodes required to be conductive (that is, conductor thin film 32 and casing upper-surface electrode 21) are precisely positioned, it is not necessary to set the positioning precision of ACF 40 itself as high as possible.

In the present embodiment, solder resist SR is present on the surface of rear conductor 13. When solder resist SR is composed of a resin, most of the surface of magnetic body 10 is covered by a film of a resin material. Even when external force or thermal stress is applied to magnetic body 10, it is possible to increase the effect of protecting magnetic body 10 by a resin film including solder resist SR. As magnetic body 10 is protected in this way, and magnetic body main surface 10B and casing main surface 20B are covered by solder resist SR, it is possible to prevent defects such as chipping or cracks that may be generated in magnetic body 10 in the mounting step. As a result, it is possible to increase the manufacturing yield of irreversible circuit device 100 and reduce costs thereof.

Next, in the present embodiment, solder balls 80 are formed on the bottom surface of irreversible circuit element P1 and circuit board 90 is joined to irreversible circuit element P1 by solder balls 80. Solder ball 80 is spherical, and thus thermal stress applied to solder ball 80 is reduced. It is thus possible to improve mechanical resistance of the members contacting solder ball 80, thus achieving high reliability. In addition, as a BGA mounting system using solder ball 80 is employed, irreversible circuit element P1 can be stably surface-mounted on mounted part P2.

In the present embodiment, since irreversible circuit device 100 has a BGA configuration using solder ball 80, irreversible circuit element P1 can be mounted and implemented on circuit board 90 simultaneously with other surface mounting electronic components other than irreversible circuit element P1. It is thus possible to reduce the operation time.

Finally, for example, if wirings above and below magnetic body 10 are formed by attaching bent metal materials, shapes of bent metal terminals formed may vary. If the shapes of the metal terminals vary as described above, the possibility that electrical characteristics of irreversible circuit device 100 may vary is increased. Even in such a case, if the BGA configuration using solder ball 80 is employed as in the present embodiment, it is possible to reduce the possibility that electrical characteristics of irreversible circuit device 100 may vary.

### Modification of First Embodiment

In the first embodiment described above, one magnetic body 10 is incorporated in one securable part 24 of magnetic body securing casing 20, so that irreversible circuit element P1 is formed. In view of reducing manufacturing costs, however, preferably, a plurality of magnetic bodies are respectively incorporated in a plurality of magnetic body securing casings 20 at the same time, so that a plurality of irreversible circuit elements P1 are formed at the same time.

FIG. 31 shows an example of a large casing 29 that achieves the manufacturing method described above. Referring to FIG. 31, large casing 29 is configured in a manner that a plurality of magnetic body securing casings 20 each of which includes securable part 24 formed at its center part as described above are connected to each other by joint parts 25. Large casing 29 constitutes an irreversible circuit device similarly to magnetic body securing casing 20 included in, for example, irreversible circuit device 100 shown in FIG. 2.

In FIG. 31, three rows of magnetic body securing casings 20 in a left-right direction and three columns of magnetic body securing casings 20 in an up-down direction are arranged in a matrix at intervals. An outer frame 26 is arranged so as to surround all magnetic body securing casings 20 in a quadrangular shape (in a frame shape) from outside. Joint part 25 is connected to the gap between magnetic body securing casings 20 and the gap between outer frame 26 and each magnetic body securing casing 20. In addition, a positioning pin hole 27 is formed at each corner of quadrangular outer frame 26 in a planar view.

Irreversible circuit elements P1 shown in FIG. 2 are simultaneously formed by magnetic body securing casings 20 included in large casing 29 having a large plane area as shown in FIG. 31. As a result, it is possible to form irreversible circuit device 100 in which irreversible circuit elements P1 are arranged in a matrix like magnetic body securing casings 20 shown in FIG. 31. A process using large casing 29 shown in FIG. 31 is preferably performed by using a heat pressing device (a large pressing device) having a large plane area. This large pressing device has higher surface accuracy and higher parallelism than a usual pressing device (for example, bonder 44 shown in FIGs. 21 to 26).

In a step of manufacturing the irreversible circuit element, (although not shown in the drawing), magnetic bodies 10 are arranged first in all securable parts 24 included in large casing 29 and secured thereto by elastic adhesive 12 as described above. Large casing 29 is then set on the large pressing device, and the large pressing device performs the process similar to steps of FIGs. 19 to 26. Thin board 30 is thus bonded and secured to large casing 29. A large thin board 30 that is larger than that in the first embodiment so as to cover substantially overall large casing 29 shown in FIG. 31 from above may be used.

When it is difficult to perform positioning using a device corresponding positioning camera 44C shown in FIG. 24 or the like, it is preferable to position large casing 29, a thin board, and an ACF (not shown) by using positioning pin hole 27.

When large casing 29 is formed as in the modification of the present embodiment, a large number of irreversible circuit elements can be formed simultaneously. It is thus possible to improve manufacturing efficiency and reduce manufacturing costs. Moreover, it is possible to achieve a configuration in which a step is hardly formed in magnetic body 10 and magnetic body 10 is hardly inclined.

In the first embodiment described above, up-down direction thicknesses of finished irreversible circuit elements P1 formed in irreversible circuit device 100 may slightly vary. Such a variation in thickness may affect electrical characteristics of magnetic body 10 included in each irreversible circuit element P1. When irreversible circuit device 100 including large casing 29 shown in FIG. 31 is formed, however, it is possible to reduce the variation in the up-down direction thickness and thus irreversible circuit elements P1 can be uniformized.

### Second Embodiment

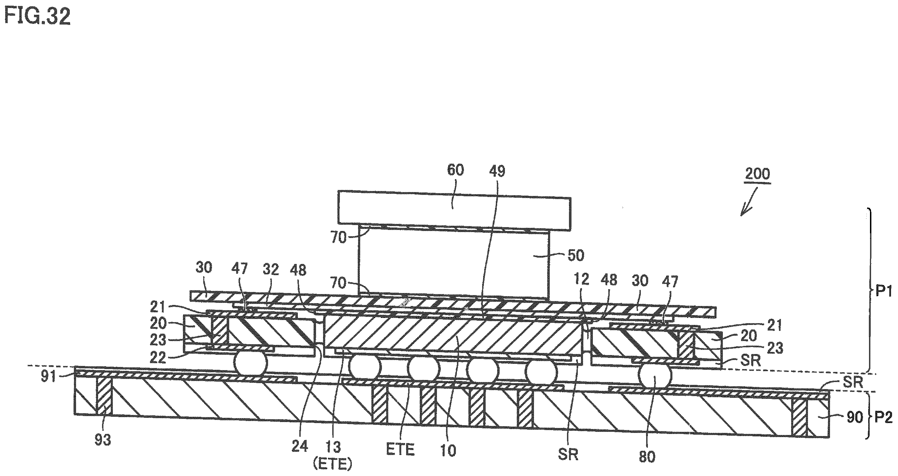

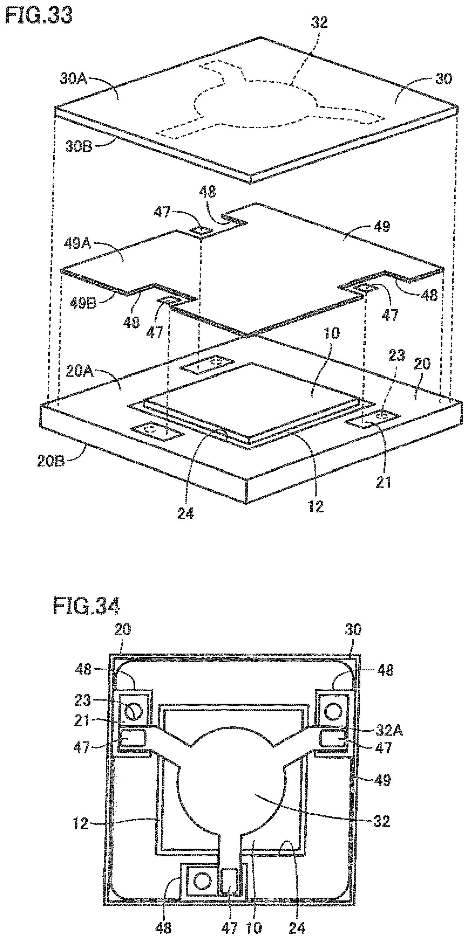

A configuration of an irreversible circuit element included in an irreversible circuit device according to the present embodiment is described first. FIG. 32 corresponds to FIG. 2 of the first embodiment, FIG. 33 corresponds to FIG. 16 of the first embodiment, and FIG. 34 corresponds to FIG. 17 of the first embodiment, respectively.

Referring to FIGs. 32 to 34, an irreversible circuit device 200 according to the present embodiment basically has a substantially similar configuration to irreversible circuit device 100 according to the first embodiment, and thus the same elements are denoted by the same reference numerals and descriptions thereof are not repeated. In irreversible circuit device 200, however, instead of ACF 40, an insulating adhesive film 49 functioning as an insulating thin film is arranged as an adhesive member arranged between thin board 30 and magnetic body 10.

Insulating adhesive film 49 has substantially the same size as ACF 40 in a planar view. In using insulating adhesive film 49, to electrically connect conductor thin film 32 of thin board 30 to casing upper-surface electrode 21 of magnetic body securing casing 20, it is not preferable to arrange insulating adhesive film 49 between conductor thin film 32 and casing upper-surface electrode 21 overlapping conductor thin film 32 so as to contact both conductor thin film 32 and casing upper-surface electrode 21. In view of preventing poor conduction in a high-frequency circuit including casing upper-surface electrode 21 or the like, it is necessary to prevent insulating adhesive film 49 from melting and flowing into surrounding regions by electrical conduction of casing upper-surface electrode 21 and the like. Consequently, a cut-away part 48 is formed at a part of an outer edge of insulating adhesive film 49 in a planar view in a manner that an interval is formed between insulating adhesive film 49 and casing upper-surface electrode 21 in a planar view. As cut-away part 48 is formed, insulating adhesive film 49 is not arranged in at least a region overlapping casing upper-surface electrode 21 (and conductor thin film 32) and a very narrow region adjacent thereto.

A conductive adhesive 47 functioning as a conductive member that is separately prepared to be spaced away from insulating adhesive film 49 is arranged outside cut-away part 48 in a planar view. Conductive adhesive 47 is provided between conductor thin film 32 of thin board 30 and casing upper-surface electrode 21 of magnetic body securing casing 20 so as to contact both conductor thin film 32 and casing upper-surface electrode 21. Conductive adhesive 47 enables conductor thin film 32 to be electrically connected to casing upper-surface electrode 21.

Conductive adhesive 47 is preferably composed of an epoxy resin conductive adhesive film that is cut into a piece according to the area of conductor thin film 32 and an electrode such as casing upper-surface electrode 21 that are connected to conductive adhesive 47, a piece of ACF or a conductive liquid resin, or a paste-like viscous body. Generally in conductive adhesive 47, in view of reducing contact resistance as low as possible, conductivity is increased by increasing the content of conductive particles filled in an adhesive contained in conductive adhesive 47. Conductive adhesive 47 thus relatively has a small content of the adhesive and not so high mechanical adhesion strength after adhesion. For this reason, in the present embodiment, to compensate for low adhesive strength of conductive adhesive 47, insulating adhesive film 49 is used as an insulating thin film having an adhesive property. The plane area of insulating adhesive film 49 is sufficiently large, and thus it is possible to achieve sufficient adhesive strength between thin board 30 and magnetic body securing casing 20 by the adhesive strength of insulating adhesive film 49 and conductive adhesive 47.

Next, a method for manufacturing irreversible circuit device 200 according to the present embodiment is described with reference to FIGs. 33 to 34 that show manufacturing steps.

The method for manufacturing irreversible circuit device 200 according to the present embodiment is basically similar to the method for manufacturing irreversible circuit device 100 according to the first embodiment, and thus descriptions of a similar manufacturing method are not repeated.

An aspect of adhesion-securing of thin board 30 and, magnetic body 10 and magnetic body securing casing 20 in the present embodiment is different from that in the first embodiment. The adhesion step is thus mainly described below.

Referring to FIG. 33, insulating adhesive film 49 and conductive adhesive 47 are prepared. The original size of thin board 30 in a planar view is preferably slightly smaller than the size of magnetic body securing casing 20. The size of insulating adhesive film 49 (cut-away part 48 is ignored) in a planar view is preferably slightly smaller than the size of thin board 30. It is preferable to determine the specific size of insulating adhesive film 49 in view of characteristics of insulating adhesive film 49.

Cut-away part 48 is formed at a part of the outer edge of insulating adhesive film 49 to prevent insulating adhesive film 49 from overlapping conductor thin film 32 and casing upper-surface electrode 21 as described above. In FIG. 33 and FIG. 34, while cut-away part 48 is formed in a rectangular shape so as to prevent insulating adhesive film 49 from overlapping conductor thin film 32 and casing upper-surface electrode 21, the shape of cut-away part 48 is not limited thereto.

Insulating adhesive film 49 is preferably an epoxy resin film in a so-called B-stage. Insulating adhesive film 49 does not need to be an epoxy resin film, and may be composed of other thermosetting resins or thermoplastic resins. In addition, insulating adhesive film 49 is arranged near a high-frequency transmission line, and thus insulating adhesive film 49 is preferably composed of a material having a low dielectric loss as possible. Originally, insulating adhesive film 49 has preferably a horizontal direction size of approximately 6.6 mm and a vertical direction size of approximately 6.6 mm in a planar view (cut-away part 48 is ignored), similarly to ACF 40 of the first embodiment. The thickness of insulating adhesive film 49 is preferably 30 µm or more and 50 µm or less, similarly to ACF 40 of the first embodiment.

An epoxy resin-based conductive adhesive film in a so-called B-stage having conductive particles such as silver mixed therein in advance is used as conductive adhesive 47. Conductive adhesive 47 does not need to be a film as described above, and may be, for example, a liquid resin or a paste-like viscous body. Conductive adhesive 47 in a state of a paste-like viscous body is supplied to a desired position on thin board main surface 30B by, for example, screen printing and a transfer method (stamping) or by using dispenser DP (see FIG. 14). Conductive adhesive 47 that is a liquid resin is supplied to a desired position by using, for example, dispenser DP. The thickness of the conductive adhesive film is preferably, for example, 30 µm or more and 50 µm or less. Conductive adhesive 47 is preferably cut into a piece so as to be capable of being sandwiched between casing upper-surface electrode 21 and conductor thin film 32 and contacting casing upper-surface electrode 21 and conductor thin film 32 in a part where casing upper-surface electrode 21 overlaps conductor thin film 32 in a planar manner.

Insulating adhesive film 49 temporarily adheres to magnetic body 10 and magnetic body securing casing 20. Specifically, this step can be described similarly to the step shown in FIGs. 19 to 22 by using insulating adhesive film 49 substituted for ACF 40 included in three-layer film 43 shown in FIGs. 19 to 23. That is, similarly to FIGs. 18(A), 18(B), and 18(C), a three-layer film in which light separator 42, insulating adhesive film 49, and heavy separator 41 are laminated in this order is sucked to bonder head 44A. After light separator 42 is separated from three-layer film 43, similarly to the step of FIG. 22, as bonder head 44A is moved downward to press magnetic body 10 and magnetic body securing casing 20, insulating adhesive film 49 temporarily adheres to magnetic body 10 and magnetic body securing casing 20 that are vacuum-sucked to heating stage 44B. As heavy separator 41 is separated as shown in FIG. 23, temporary adhesion of insulating adhesive film 49 is performed in a manner that a film lower-side main surface 49B of insulating adhesive film 49 is bonded to the surface of magnetic body 10 and the like and a film upper-side main surface 49A opposing film lower-side main surface 49B is faced upward, as shown in FIG. 33. To increase adhesive force at the time of temporary adhesion of insulating adhesive film 49, magnetic body 10 and magnetic body securing casing 20 may be appropriately heated at a temperature equal to or lower than the heat setting temperature of insulating adhesive film 49. Temporary adhesion of insulating adhesive film 49 has been described above, and further detailed descriptions thereof are omitted.

When temporary adhesion of conductive adhesive 47 is then performed, insulating adhesive film 49 has already temporarily adhered to magnetic body 10 and magnetic body securing casing 20. Therefore, similarly to the step of FIG. 24, conductive adhesive 47 temporarily adheres to a desired position on thin board main surface 30B of thin board 30 that is vacuum-sucked to bonder head 44A. Preferably, conductive adhesive 47 also temporarily adheres to thin board main surface 30B by using bonder 44.

In the step of FIG. 24, semi-transparency of ACF 40 is used to position conductor thin film 32 with respect to casing upper-surface electrode 21 that can be viewed through ACF 40 in the first embodiment. Meanwhile, in the present embodiment, semi-transparency of conductive adhesive 47 temporarily adhering to thin board 30 may be used to position conductor thin film 32. When conductive adhesive 47 is not semi-transparent, positioning may be performed by using conductive adhesive 47 having a smaller outline size than conductor thin film 32. If it is difficult to perform such a process, for example, a dedicated positioning mark may be given to magnetic body securing casing 20 and thin board 30 and positioning may be performed by secondarily using these marks.

While the second embodiment is different from the first embodiment in that conductor thin film 32 (thin board 30) is positioned by using conductive adhesive 47, basically similar steps to those of FIGs. 24 to 26 are performed at the time of adhesion of thin board 30. Conductive adhesive 47 and thin board 30 thus permanently adhere to magnetic body securing casing 20 having magnetic body 10 secured thereto and insulating adhesive film 49. Temporary adhesion of conductive adhesive 47 has been described, and further detailed descriptions thereof are omitted.

The present embodiment is different from the first embodiment in the points described above, but is basically similar to the first embodiment in other points, and thus detailed descriptions thereof are omitted.

Next, an operation and effect of the present embodiment are described. In addition to a similar operation and effect to the first embodiment, the present embodiment has the following operations and effects.

In the present embodiment, insulating adhesive film 49 is used instead of ACF 40 of the first embodiment. It is thus possible to manufacture irreversible circuit device 200 that has similar performance to irreversible circuit device 100 of the first embodiment without using an ACF with expensive material costs.

In addition, by using insulating adhesive film 49 instead of ACF 40, it is possible to further increase the adhesive strength of magnetic body securing casing 20 having magnetic body 10 secured thereto and thin board 30 as compared to the first embodiment.

### Modification of Second Embodiment

As described above, in the present embodiment, insulating adhesive film 49 and the like are made to adhere by using bonder 44, basically similarly to the first embodiment. That is, bonder 44 simultaneously performs heating and pressing, thus performing adhesion. However, insulating adhesive film 49 may adhere to magnetic body 10 and the like by pressing under room temperature conditions without heating. In this case, it is preferable to use, as insulating adhesive film 49, an insulating double-faced adhesive film that has an adhesive property on both film upper-side main surface 49A and film lower-side main surface 49B shown in FIG. 33. In this case, it is preferable to select, as the insulating double-faced adhesive film, a material that can stand a temperature at the time of reflow-mounting irreversible circuit element P1 on circuit board 90.

### Third Embodiment

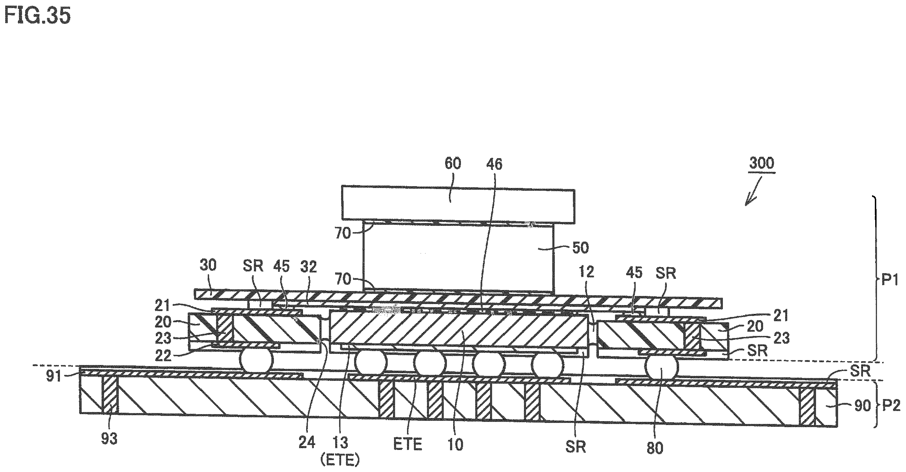

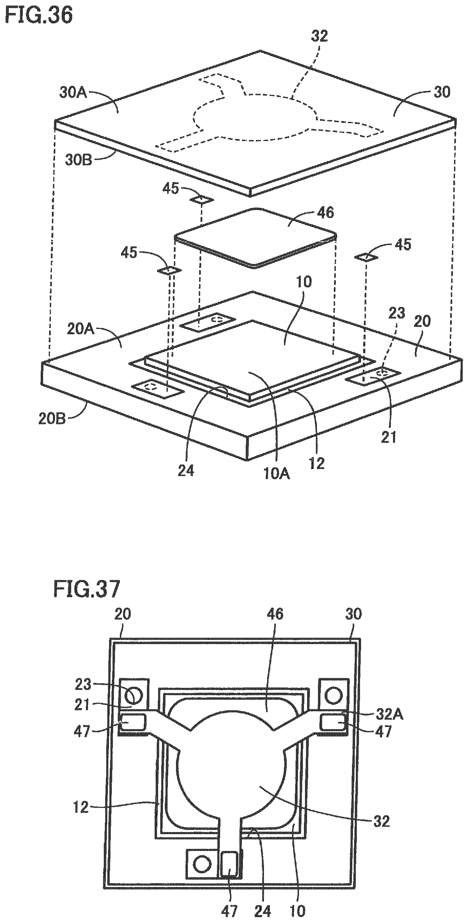

A configuration of an irreversible circuit element included in an irreversible circuit device according to the present embodiment is described first. FIG. 35 corresponds to FIG. 2 of the first embodiment, FIG. 36 corresponds to FIG. 16 of the first embodiment, and FIG. 37 corresponds to FIG. 17 of the first embodiment, respectively.

Referring to FIGs. 35 to 37, an irreversible circuit device 300 according to the present embodiment basically has a substantially similar configuration to irreversible circuit device 100 according to the first embodiment, and thus the same elements are denoted by the same reference numerals and descriptions thereof are not repeated. In irreversible circuit device 300, however, instead of ACF 40, an insulating liquid adhesive 46 is arranged between thin board 30 and magnetic body 10 as a liquid adhesive having an insulating property. The liquid adhesive means an adhesive that is liquid in an initial state before being cured.

Similarly to the second embodiment, ACF 40 is not used in the present embodiment. To electrically connect conductor thin film 32 of thin board 30 to casing upper-surface electrode 21 of magnetic body securing casing 20, it is preferable to arrange not insulating adhesive film 49 but a conductive member in a region where conductor thin film 32 overlaps casing upper-surface electrode 21. In the present embodiment, conductor thin film 32 of thin board 30 is electrically connected to casing upper-surface electrode 21 of magnetic body securing casing 20 by a pre-coated solder 45 (solder) functioning as a conductive member.

Pre-coated solder 45 (solder) basically has higher joining strength than conductive adhesive 47 that is a conductive member of the second embodiment. In the present embodiment, conductor thin film 32 of thin board 30 can thus adhere to casing upper-surface electrode 21 of magnetic body securing casing 20 with higher joining strength than the second embodiment. In the present embodiment, it is thus possible to reduce the area of a region where thin board 30 needs to adhere to underlying magnetic body 10 and magnetic body securing casing 20 as compared to the second embodiment.

The area of the region where thin board 30 needs to adhere to magnetic body 10 and magnetic body securing casing 20 in the present embodiment means the area of region thin board 30 needs to adhere to magnetic body 10 and magnetic body securing casing 20 in view of electrical characteristics of a high-frequency circuit. This region corresponds to a part in which the transmission line described above is formed. In view of this fact, it is basically preferable that magnetic body 10 adhere to thin board 30 immediately above magnetic body 10 as close as possible. The area of the region where thin board 30 needs to adhere to magnetic body 10 and magnetic body securing casing 20 is (equal to or smaller than) the area of magnetic body 10 in a planar view. In addition, it is preferable that no gap be present between magnetic body 10 and thin board 30 that adhere to each other.

In the present embodiment, insulating liquid adhesive 46 is arranged only in the region between thin board 30 and magnetic body 10. That is, magnetic body securing casing 20 adheres to thin board 30 only in the region where casing upper-surface electrode 21 adheres to conductor thin film 32 by pre-coated solder 45. Consequently, the area of insulating liquid adhesive 46 in a planar view is much smaller than, for example, the area of conductive adhesive 47 of the second embodiment (and ACF 40 of the first embodiment).

Insulating liquid adhesive 46 is preferably composed of, for example, an epoxy resin adhesive. For the epoxy resin adhesive functioning as insulating liquid adhesive 46, it is preferable to use not a two-liquid mixing epoxy resin adhesive in which a main agent and a curing agent are separately prepared but a one-liquid epoxy resin adhesive in which a main agent and a curing agent are mixed in advance and a mixture is supplied by a syringe. As the one-liquid epoxy resin adhesive is used, insulating liquid adhesive 46 is easily handled and thus operational efficiency is improved. More specifically, it is possible to use a die bonding resin for a semiconductor or an underfill resin as insulating liquid adhesive 46. These resins are evaluated in advance and then used.

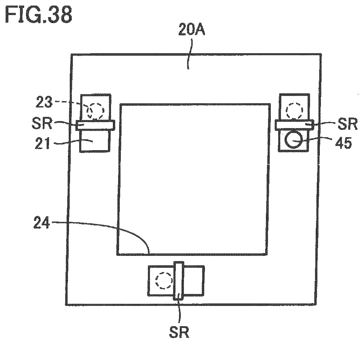

Next, a method for manufacturing irreversible circuit device 300 according to the present embodiment is described with reference to FIGs. 36 to 37 that show manufacturing steps. FIG. 38 shows a mechanism for preventing outflow of pre-coated solder 45.

The method for manufacturing irreversible circuit device 300 according to the present embodiment is basically similar to the method for manufacturing irreversible circuit device 100 according to the first embodiment, and thus descriptions of a similar manufacturing method are not repeated.

As described above, an aspect of adhesion-securing of thin board 30 and, magnetic body 10 and magnetic body securing casing 20 in the present embodiment is different from that in the first embodiment. The adhesion step is thus mainly described below.

Referring to FIG. 36, after forming magnetic body securing casing 20 having magnetic body 10 secured thereto, a required amount of pre-coated solder 45 that is a solid is supplied in advance on casing upper-surface electrode 21 of magnetic body securing casing 20 by a solder precoating method. In the present embodiment, pre-coated solder 45 is supplied before an insulating liquid adhesive is supplied.

Pre-coated solder 45 is supplied on a desired position on casing upper-surface electrode 21 by supplying a solder paste on the desired position by, for example, screen printing and a transfer method (stamping) or by using dispenser DP (see FIG. 14). Pre-coated solder 45 is preferably supplied to the region on casing upper-surface electrode 21 other than the region overlapping through-conductor 23 immediately below casing upper-surface electrode 21. Magnetic body securing casing 20 having magnetic body 10 secured thereto is then put into a reflow furnace and heated, so that the solder paste supplied is melted. After passing through a high-temperature environment in the reflow furnace, the solder paste is cooled and solidified. A solid solder layer is thus supplied as pre-coated solder 45 on casing upper-surface electrode 21.

Referring to FIGs. 35 and 38, pre-coated solder 45 is preferably supplied to the partial region on casing upper-surface electrode 21 other than the region overlapping through-conductor 23, and solder resist SR is formed in the region between the pre-coated solder 45 supply region and the region overlapping through-conductor 23. Solder resist SR is composed of a similar material to solder resist SR of the first embodiment. Consequently, solder resist SR functions as a dam for preventing melted pre-coated solder 45 from flowing into a through-hole in magnetic body securing casing 20.

Next, after pre-coated solder 45 is supplied, thin board 30 adheres to magnetic body 10 by insulating liquid adhesive 46.

Similarly to the case of supplying a solder paste described above, a predetermined amount of insulating liquid adhesive 46 is supplied on magnetic body main surface 10A on the upper side of magnetic body 10 by, for example, screen printing and a transfer method (stamping) or by using dispenser DP (see FIG. 14). In view of achieving the best operational efficiency, however, it is the most preferable to supply insulating liquid adhesive 46 by using dispenser DP. As the amount of insulating liquid adhesive 46 supplied, it is preferable to use an optimum value that is determined in a manner that insulating liquid adhesive 46 that is extended at the time of adhesion does not affect other regions.

Afterward, by performing the process using bonder 44 similarly to the steps of FIGs. 24 to 26 in the first embodiment, thin board 30 is adhesion-secured to magnetic body 10. In the present embodiment, ACF 40 or the like is not superimposed on the outermost part of casing upper-surface electrode 21, and it is possible to position thin board 30 while visually checking casing upper-surface electrode 21.

Also in the present embodiment, heating and pressuring are simultaneously performed by using bonder 44, and thus thin board 30 can adhere to magnetic body 10. In the present embodiment, however, it is possible to perform the adhesion step described above in a heating and drying furnace or the like while compensating for, if needed, heating and pressing by using, in addition to bonder 44 described above, a device or a jig that can externally apply a load such as a heating press, a spring, and a weigh. Consequently, insulating liquid adhesive 46 is heated and cured more reliably and thus more solid adhesion is achieved.

Next, after insulating liquid adhesive 46 is cured, pre-coated solder 45 on casing upper-surface electrode 21 is heated to be melted and casing upper-surface electrode 21 is solder-joined to thin board 30. In this step, magnetic body 10 and magnetic body securing casing 20 may be preheated to a temperature of 100°C or higher by using heating stage 44B of bonder 44 according to the first embodiment, and then heat may be applied from above of thin board 30 by heating bonder head 44A. In this step, however, pre-coated solder 45 may be heated to be melted by using not bonder 44 but a heating tool that can perform local heating such as a soldering iron.

While insulating liquid adhesive 46 is heated and cured first and then connection using pre-coated solder 45 is performed, these steps may be performed in the reverse order. In particular, when bonder 44 described above is used, heating and curing of insulating liquid adhesive 46 and heating and melting of pre-coated solder 45 may be simultaneously performed and joining may be performed simultaneously by insulating liquid adhesive 46 and pre-coated solder 45.

It is preferable not to use a flux in the connection part using pre-coated solder 45 in the present embodiment. It is thus possible to prevent corrosion or migration of casing upper-surface electrode 21 and conductor thin film 32 caused by a flux residue. Soldering that achieves high reliability even though a flux is not used is achieved by flash plating a gold thin film on the surface of conductor thin film 32.

The present embodiment is different from the first embodiment in the points described above, but is basically similar to the first embodiment in other points, and thus detailed descriptions thereof are omitted.

Next, an operation and effect of the present embodiment are described. In addition to a similar operation and effect to the first embodiment, the present embodiment has the following operations and effects.

In the present embodiment, conductor thin film 32 of thin board 30 can adhere to casing upper-surface electrode 21 of magnetic body securing casing 20 by using pre-coated solder 45 described above with higher strength than the first and second embodiments. It is thus possible to reduce the area of the region where thin board 30 needs to adhere to magnetic body 10 and magnetic body securing casing 20 underlying thin board 30 as compared to the second embodiment.

Thin board 30 adheres only to magnetic body 10 (except for casing upper-surface electrode 21). As compared to a case where thin board 30 adheres to both magnetic body 10 and magnetic body securing casing 20, thin board 30 can adhere stably to magnetic body 10 in a state where thin board 30 and magnetic body 10 are close to each other.

Such securing is achieved by insulating liquid adhesive 46. If insulating liquid adhesive 46 is used, it is possible to improve adhesion of magnetic body 10 and thin board 30 as compared to a case of using, for example, ACF 40 or insulating adhesive film 49 having the same size as insulating liquid adhesive 46 according to the present embodiment (a size equal to or smaller than magnetic body 10). This is because insulating liquid adhesive 46 has higher adhesive strength than ACF 40 and insulating adhesive film 49.

In addition, by using insulating liquid adhesive 46, the area of the adhesive member in a planar view can be reduced as compared to the area in the first and second embodiments. That is, the amount of a material used for manufacturing the adhesive member is reduced and manufacturing costs can thus be reduced accordingly.

Insulating liquid adhesive 46 is more inexpensive than ACF 40 and insulating adhesive film 49. In view of this fact, it is possible to reduce manufacturing costs by using insulating liquid adhesive 46.

In the present embodiment, an adhesive member is arranged only on magnetic body 10 and is not arranged on magnetic body securing casing 20. Consequently, as compared to a case of arranging the adhesive member also on magnetic body securing casing 20 as in the first and second embodiments, it is possible to prevent a failure, that is, to prevent the adhesive member from being extended after adhesion. It is thus possible to improve the degree of freedom from a manufactural or dimensional point of view.

### Modification of Third Embodiment

In the present embodiment, although material costs are increased as compared to the case described above, instead of insulating liquid adhesive 46 described above, insulating adhesive film 49 described in the second embodiment or an insulating double-faced adhesive film that is adherable at a room temperature may be used. In addition, pre-coated solder 45 may be used as a conductive member similarly to the case described above.

In the above description, pre-coated solder 45 is used as a conductive material for adhesion of casing upper-surface electrode 21 and conductor thin film 32. However, when it is possible to achieve adhesive strength equivalent to that of pre-coated solder 45, or when other problems about the strength do not arise, casing upper-surface electrode 21 can adhere to conductor thin film 32 by using a conductive member other than a solder. For example, casing upper-surface electrode 21 can adhere to conductor thin film 32 by ultrasonic joining or heating and pressing stud bumps formed of thin metal wires composed of gold instead of solder bumps.

### Fourth Embodiment

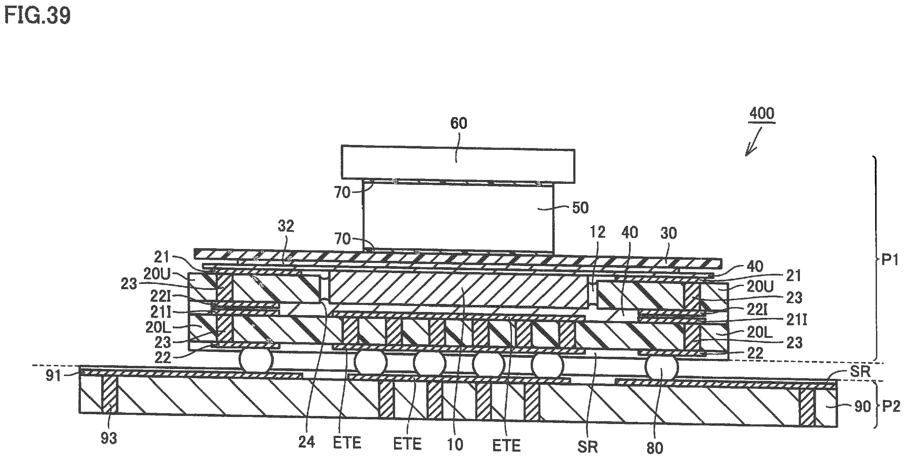

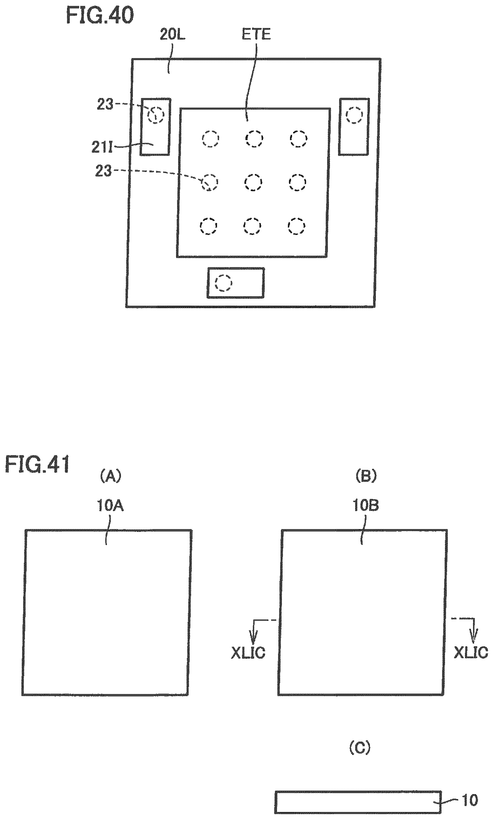

A configuration of an irreversible circuit element included in an irreversible circuit device according to the present embodiment is described first. FIG. 39 corresponds to FIG. 2 of the first embodiment. FIG. 40 is shown from a similar view to FIGs. 7 and 10 of the first embodiment. FIG. 41 corresponds to FIG. 5 of the first embodiment.

Referring to FIG. 39, an irreversible circuit device 400 according to the present embodiment basically has a substantially similar configuration to irreversible circuit device 100 according to the first embodiment, and thus the same elements are denoted by the same reference numerals and descriptions thereof are not repeated. In irreversible circuit device 400, magnetic body securing casing 20 is constituted by an upper-side casing 20U functioning as a first magnetic body securing casing part and a lower-side casing 20L functioning as a second magnetic body securing casing part. That is, magnetic body securing casing 20 according to the present embodiment is constituted by a combination of two printed boards. Magnetic body securing casing 20 according to the present embodiment is different from magnetic body securing casing 20 according to the first to third embodiments that is constituted as a single printed board in this point.

Upper-side casing 20U and lower-side casing 20L are formed to have, for example, a quadrangular (square) planar shape in a planar view and have substantially the same outline size. Upper-side casing 20U and lower-side casing 20L are thus arranged to substantially overlap with each other in a planar view. In addition, upper-side casing 20U and lower-side casing 20L are composed of the same material. This material is the same as that of magnetic body securing casing 20 according to the first to third embodiments.

Similarly to magnetic body securing casing 20 of the first to third embodiments, upper-side casing 20U includes securable part 24 and is arranged so as to surround magnetic body 10 arranged in securable part 24 from an outer circumferential side in a planar view. Meanwhile, lower-side casing 20L is arranged so as to cover (surround) magnetic body 10 from the lower side (other side) of magnetic body 10.

Referring to FIGs. 39 and 40, casing upper-surface electrode 21 is formed on a main surface on the upper side of upper-side casing 20U and casing lower-surface electrode 22 is formed on a main surface on the lower side of lower-side casing 20L. An interposing lower-surface electrode 221 is formed on a main surface on the lower side of upper-side casing 20U and an interposing upper-surface electrode 211 is formed on a main surface on the upper side of lower-side casing 20L. Preferably, interposing lower-surface electrode 221 and interposing upper-surface electrode 211 basically have the substantially same shape and size, and are composed of the same material.

Through-conductor 23 is formed in upper-side casing 20U so as to pass through upper-side casing 20U from casing upper-surface electrode 21 to interposing lower-surface electrode 221. Through-conductor 23 is formed in lower-side casing 20L so as to pass through lower-side casing 20L from interposing upper-surface electrode 211 to casing lower-surface electrode 22. In addition, interposing lower-surface electrode 221 preferably opposes interposing upper-surface electrode 211 at an interval therebetween.

Unlike upper-side casing 20U, lower-side casing 20L does not include an opening like securable part 24. As described above, upper-side casing 20U and lower-side casing 20L are arranged so as to overlap with each other in a planar view, and thus a part constituting the main body of lower-side casing 20L is arranged in a region immediately below magnetic body 10.

Earth electrode ETE that is on the same layer as interposing upper-surface electrode 211 is formed on the top surface of lower-side casing 20L in the region immediately below magnetic body 10 held by upper-side casing 20U. Similarly to magnetic body 10 shown in FIG. 5 and magnetic body securing casing 20 shown in FIG. 8, interposing upper-surface electrode 21I and earth electrode ETE are formed by patterning a thin film of a conductor material on a surface on the upper side of lower-side casing 20L. Earth electrode ETE that is on the same layer as casing lower-surface electrode 22 is formed on the bottom surface of lower-side casing 20L in the region immediately below magnetic body 10. Similarly to magnetic body 10 shown in FIG. 5 and magnetic body securing casing 20 shown in FIG. 8, casing lower-surface electrode 22 and earth electrode ETE are formed by patterning a thin film of a conductor material on a surface on the lower side of lower-side casing 20L. Through-conductor 23 is formed to pass through lower-side casing 20L between earth electrodes ETE in the region immediately below magnetic body 10.

As described above, lower-side casing 20L is filled with a material that composes lower-side casing 20L in the region immediately below magnetic body 10 (except for a through-hole). A recess part is formed in magnetic body securing casing 20 by the top surface of lower-side casing 20L in the region immediately below magnetic body 10 (the surface that is on the same layer as interposing upper-surface electrode 211 and on which earth electrode ETE is formed) and by an inner wall surface of securable part 24 formed in upper-side casing 20U immediately above the top surface. That is, the recess part is formed so as to align with securable part 24 (as securable part 24). The recess part includes, as the bottom surface, the surface that is on the same layer as interposing upper-surface electrode 211 and on which earth electrode ETE is formed, and thus magnetic body 10 arranged in securable part 24 (in the recess part) can be supported not only from the side but also from below.

The bottom surface of upper-side casing 20U including interposing lower-surface electrode 221 opposes the top surface of lower-side casing 20L including interposing upper-surface electrode 211 and ACF 40 that is similar to that of the first embodiment is arranged between the bottom surface and the top surface. ACF 40 enables upper-side casing 20U to be joined to and integrated with lower-side casing 20L. In addition, ACF 40 enables opposing interposing lower-surface electrode 221 and interposing upper-surface electrode 211 to be electrically connected to each other.

Moreover, ACF 40 enables magnetic body main surface 10B on the lower side of magnetic body 10 to be electrically and mechanically connected to earth electrode ETE on the top surface of lower-side casing 20L and the like. Consequently, in the present embodiment, unlike the first to third embodiments, solder ball 80 is not connected to the immediately underside of magnetic body 10 with rear conductor 13 interposed therebetween, and solder resist SR, solder resist cavity SRC, and rear conductor 13 are not formed on magnetic body main surface 10B on the lower side of magnetic body 10.

FIGs. 41(A) and 41(B) show the planar shape of magnetic body 10 in the present embodiment. FIG. 41(C) is a schematic cross-sectional view taken along a line XLIC-XLIC of FIG. 41(B). Referring to FIG. 41, in the present embodiment, the base that composes magnetic body 10, for example, ferrite is exposed on magnetic body main surface 10A on the upper side (one side) of magnetic body 10 and magnetic body main surface 10B on the lower side (other side) of magnetic body 10. Meanwhile, the bottom surface of lower-side casing 20L is directly connected to solder ball 80 and thus solder resist SR, solder resist cavity SRC, and a rear conductor (earth electrode ETE that is on the same layer as solder resist SR, solder resist cavity SRC, and the rear conductor) are formed on the bottom surface of lower-side casing 20L, similarly to magnetic body main surface 10B shown in FIG. 5(B). Similarly to other embodiments, the bottom part of solder ball 80 is connected to earth electrode ETE that is on the same layer as circuit board conductor 91.

In irreversible circuit device 400 shown in FIG. 39, thin board 30 adheres to magnetic body 10 and upper-side casing 20U by ACF 40 as in the first embodiment. However, also in the present embodiment, thin board 30 may adhere to magnetic body 10 and upper-side casing 20U by a similar aspect to irreversible circuit device 200 according to the second embodiment or irreversible circuit device 300 according to the third embodiment. Similarly to the first embodiment, in the present embodiment, the upper-side main surfaces of magnetic body 10 and magnetic body securing casing 20 are preferably joined to conductor thin film 32 of thin board 30 in a state where the upper-side main surfaces and conductor thin film 32 are as close as possible in view of characteristics of a transmission line.

Next, a method for manufacturing irreversible circuit device 400 according to the present embodiment is described.

The method for manufacturing irreversible circuit device 400 according to the present embodiment is basically similar to the method for manufacturing irreversible circuit device 100 according to the first embodiment, and thus descriptions of a similar manufacturing method are not repeated.

As described above, the present embodiment is different from the first embodiment in that magnetic body securing casing 20 includes upper-side casing 20U and lower-side casing 20L and upper-side casing 20U is bonded to lower-side casing 20L. A method for forming magnetic body securing casing 20 is thus mainly described below.

Magnetic body 10 is arranged in securable part 24 of upper-side casing 20U and secured to upper-side casing 20U by elastic adhesive 12 as in the first embodiment. Next, by a similar process to the steps shown in FIGs. 19 to 26 in the first embodiment, upper-side casing 20U is secured to and integrated with lower-side casing 20L with ACF 40 interposed therebetween by using bonder 44 and three-layer film 43 (including ACF 40).

In the present embodiment, however, upper-side casing 20U, lower-side casing 20L, and magnetic body 10 may be simultaneously made to adhere with ACF 40 interposed therebetween by using bonder 44 that is similar to that of FIGs. 19 to 26 and after the adhesion is completed, elastic adhesive 12 may be injected into the gap between securable part 24 of upper-side casing 20U and magnetic body 10 to secure magnetic body 10 to upper-side casing 20U.

A decrease in the viscosity of ACF 40 at the time of heating and pressing is less than that of a liquid resin material. It is thus unnecessary to perform a process of filling a through-hole in advance at the time of the adhesion described above.

The present embodiment is different from the first embodiment in the points described above, but is basically similar to the first embodiment in other points, and thus detailed descriptions thereof are omitted.

Next, an operation and effect of the present embodiment are described. In addition to a similar operation and effect to the first embodiment, the present embodiment has the following operations and effects.

In the present embodiment, magnetic body 10 that is surrounded and held by securable part 24 of upper-side casing 20U is accommodated in the recess part formed by the inner wall surface of securable part 24 and the surface of lower-side casing 20L on the lower side of securable part 24. In the first to third embodiments, rear conductor 13, solder resist SR, and the like are not directly formed on magnetic body main surface 10B on the lower side of magnetic body 10. It is thus possible to significantly reduce manufacturing costs for magnetic body 10.

As a result of cost analysis of irreversible circuit device 400 according to the present embodiment, it is found that in particular, machining of a through-hole in magnetic body 10 and machining of solder resist SR on magnetic body 10 may incur 80% or more of the overall cost required to manufacture irreversible circuit device 400. That is, even if the configuration of magnetic body securing casing 20 is more completed than that of the first to third embodiments as in the present embodiment, it is possible to reduce the overall manufacturing cost by eliminating the step of forming rear conductor 13 and solder resist SR on magnetic body main surface 10B. This is because a material that composes magnetic body 10 such as ferrite is hard and difficult to be machined, defects such as breaking and chipping easily occur, and the adhesive force of the material to a plated film and a resin film is low.

### Fifth Embodiment

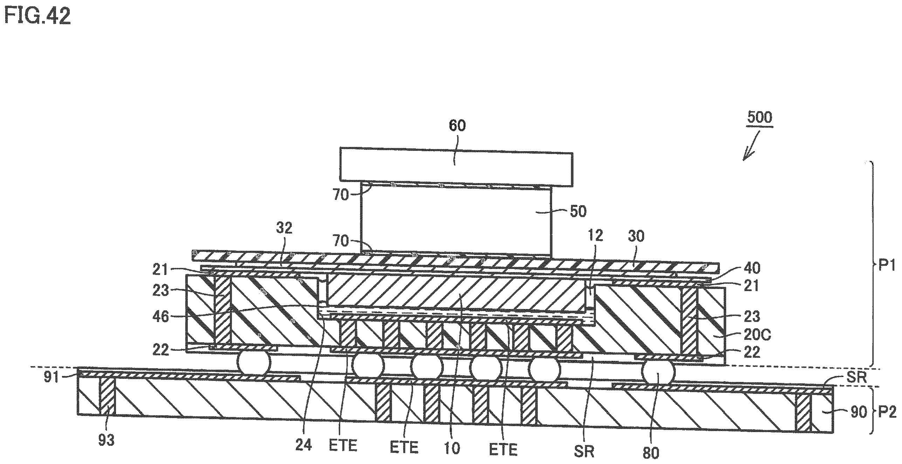

A configuration of an irreversible circuit element included in an irreversible circuit device according to the present embodiment is described first. FIG. 42 corresponds to FIG. 2 of the first embodiment.

Referring to FIG. 42, an irreversible circuit device 500 according to the present embodiment basically has a substantially similar configuration to irreversible circuit device 400 according to the fourth embodiment, and thus the same elements are denoted by the same reference numerals and descriptions thereof are not repeated. In irreversible circuit device 500, a magnetic body securing casing 20C that corresponds to magnetic body securing casing 20 of the fourth embodiment includes a first part and a second part, and these first and second parts are integrally formed. The first part is a part of magnetic body securing casing 20C in which securable part 24 is formed and that is arranged to surround securable part 24 from an outer circumferential side in a planar view, and corresponds to upper-side casing 20U of the fourth embodiment. That is, the first part is arranged in a position similar to that of upper-side casing 20U and has a similar shape to upper-side casing 20U. The second part is arranged to cover (surround) the first part including securable part 24 from the lower side thereof (other side, that is, the side of circuit board 90), is integrated with the first part, and corresponds to lower-side casing 20L of the fourth embodiment. That is, the second part is arranged in a position similar to that of lower-side casing 20L and has a similar shape to lower-side casing 20L.

Consequently, the second part does not include an opening like securable part 24 of the first part and has a substantially flat plate shape. A recess part is formed in magnetic body securing casing 20 by a top surface of the second part and an inner wall surface of securable part 24 of the first part arranged immediately above the second part. Magnetic body 10 is accommodated in the recess part and secured in the recess part (securable part 24) by elastic adhesive 12.

Magnetic body securing casing 20C is configured as a casing that includes a recess part that can accommodate magnetic body 10 therein.

Earth electrode ETE is formed on a surface of the recess part, corresponding to the top surface of the second part. Similarly to the fourth embodiment, earth electrode ETE is electrically connected to earth electrode ETE on the bottom part of the second part (that is on the same layer as casing lower-surface electrode 22) with through-conductor 23 that passes through the second part immediately below earth electrode ETE interposed therebetween. In the present embodiment, the first part is integrated with the second part, and thus casing upper-surface electrode 21 is directly electrically connected to casing lower-surface electrode 22 with through-conductor 23 interposed therebetween on the circumferential side of magnetic body 10 in a planar view. That is, in the present embodiment, ACF 40 of the fourth embodiment that connects upper-side casing 20U to lower-side casing 20L is not arranged.

In the present embodiment, however, a conductive member is not arranged in securable part 24, and magnetic body 10 in securable part 24 (recess part) is secured to the second part of magnetic body securing casing 20C at the lower side of magnetic body 10 by using insulating liquid adhesive 46. Insulating liquid adhesive 46 has a similar composition to insulating liquid adhesive 46 used in the third embodiment.

Next a method for manufacturing irreversible circuit device 500 according to the present embodiment is described.

The method for manufacturing irreversible circuit device 500 according to the present embodiment is basically similar to the method for manufacturing irreversible circuit device 400 according to the fourth embodiment, and thus descriptions of a similar manufacturing method are not repeated.

As described above, the present embodiment is different from the fourth embodiment in that magnetic body securing casing 20C is configured by integrating the first part corresponding to upper-side casing 20U of the fourth embodiment with the second part corresponding to lower-side casing 20L of the fourth embodiment. For example, magnetic body securing casing 20C obtained by integrating two parts is formed as follows.

For example, a multi-layer printed board in which a printed board functioning as the first part is laminated and pressed on a printed board functioning as the second part is formed. Cutting is then performed on a part of the printed board functioning as the first part (in particular, a center part in a planar view) by using an end mill or the like, so that securable part 24 functioning as an opening is formed.

Magnetic body 10 is accommodated in magnetic body securing casing 20C formed and secured thereto as follows. As described above, insulating liquid adhesive 46 is supplied into securable part 24 in the present embodiment, and thus magnetic body 10 and earth electrode ETE immediately below magnetic body 10 do not electrically conduct with each other. However, in the present embodiment, similarly to other embodiments, it is preferable that magnetic body 10, thin board 30, and conductor thin film 32 be close to each other as possible and not gap be present between magnetic body 10, thin board 30, and conductor thin film 32.

Insulating liquid adhesive 46 is supplied first on the surface of earth electrode ETE in securable part 24 of magnetic body securing casing 20C (the bottom surface of securable part 24). It is preferable to supply insulating liquid adhesive 46 by a transfer method (stamping) or by using dispenser DP (see FIG. 14) in the third embodiment. It is particularly preferable to supply insulating liquid adhesive 46 by using dispenser DP.

After insulating liquid adhesive 46 is supplied as described above, magnetic body securing casing 20C is set in bonder 44 similar to that of the first embodiment (see FIGs. 21 to 26) and magnetic body 10 is arranged in securable part 24. Insulating liquid adhesive 46 is then heated to be cured by, for example, heating stage 44B of bonder 44.

Afterward, similarly to the first embodiment, magnetic body 10 adheres to magnetic body securing casing 20C (securable part 24) by using bonder 44. As described in the third embodiment, it is possible to perform the adhesion step described above in a heating and drying furnace or the like while compensating for, if needed, heating and pressing by using, in addition to bonder 44 described above, a device or a jig that can externally apply a load such as a heating press, a spring, and a weigh. Consequently, insulating liquid adhesive 46 is heated and cured more reliably and thus more solid adhesion is achieved.

Similarly to the step of the first embodiment shown in FIG. 14, elastic adhesive 12 is then supplied between the inner wall surface of securable part 24 and magnetic body 10 by using dispenser DP and cured.

The present embodiment is different from the fourth embodiment in the points described above, but is basically similar to the fourth embodiment in other points, and thus detailed descriptions thereof are omitted.

Next, an operation and effect of the present embodiment are described. In addition to a similar operation and effect to the fourth embodiment, the present embodiment has the following operations and effects.

In the present embodiment, magnetic body securing casing 20C is configured in a manner that the first part corresponding to upper-side casing 20U of the fourth embodiment is integrated with the second part corresponding to lower-side casing 20L thus functioning as a member. Consequently, as compared to a case where magnetic body securing casing 20 is constituted of two members, that is, upper-side casing 20U and lower-side casing 20L as in the fourth embodiment, it is possible to reduce the number of manufacturing steps and to provide magnetic body securing casing 20C as a single member.

In addition, in the present embodiment, magnetic body 10 is secured to the second part of magnetic body securing casing 20C without arranging a conductive member in securable part 24. That is, a conductive member that is always present on magnetic body main surface 10B on the lower side of magnetic body 10 in other embodiments described above is not arranged. Similarly to the fourth embodiment, it is thus possible to eliminate the step of forming solder resist SR on magnetic body main surface 10B also in the present embodiment. As described in the fourth embodiment, it is possible to significantly reduce machining costs for magnetic body 10, thus reducing overall manufacturing costs.

In addition, magnetic body securing casing 20C is a multi-layer printed board obtained by laminating the first part on the second part in the present embodiment. For this reason, it is possible to achieve a solid shield structure as compared to a case where magnetic body securing casing 20 is a single-layer printed board.

### Modification of Fifth Embodiment

Also in the present embodiment, magnetic body 10 may adhere to magnetic body securing casing 20C by using, for example, ACF 40 instead of insulating liquid adhesive 46. If expensive material costs for ACF 40 are problematic, however, insulating adhesive film 49 of the second embodiment or an insulating double-faced adhesive film that is adherable at a room temperature may be used instead of ACF 40.

Alternatively, elastic adhesive 12 may be used not only in the adhesion step of magnetic body 10 to the inner wall surface of securable part 24 but also in the adhesion step of magnetic body 10 to the bottom surface of securable part 24. That is, it may be configured in a manner that, as a whole, magnetic body 10 is secured to magnetic body securing casing 20C only by elastic adhesive 12.

### Sixth Embodiment

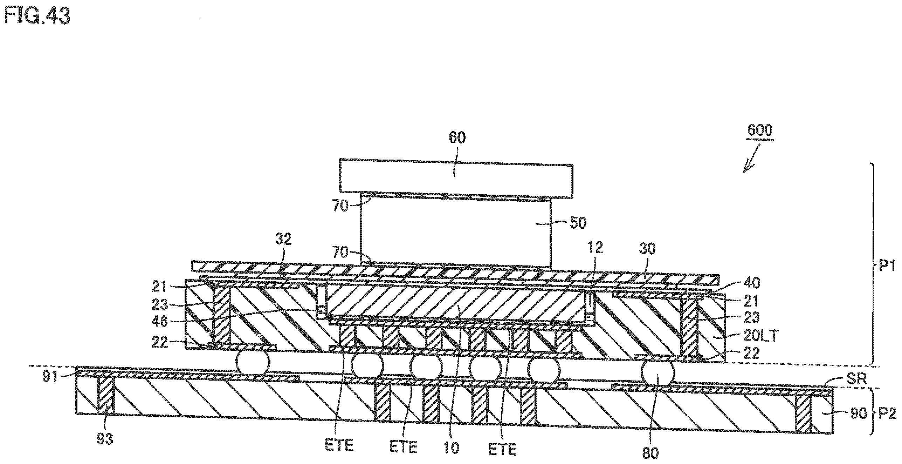

A configuration of an irreversible circuit element included in an irreversible circuit device according to the present embodiment is described first. FIG. 43 corresponds to FIG. 2 of the first embodiment.

Referring to FIG. 43, an irreversible circuit device 600 according to the present embodiment basically has a substantially similar configuration to irreversible circuit device 500 according to the fifth embodiment, and thus the same elements are denoted by the same reference numerals and descriptions thereof are not repeated. In irreversible circuit device 600, a magnetic body securing casing 20LT that has the same shape and function as magnetic body securing casing 20C of the fifth embodiment is composed of a ceramic material instead of the organic resin material of the fifth embodiment.

Magnetic body securing casing 20LT is preferably composed of, for example, LTCC (Low Temperature Co-fired Ceramics). Alternatively, magnetic body securing casing 20LT may be composed of, for example, HTCC (High Temperature Co-fired Ceramics).

While magnetic body securing casing 20 is basically composed of an organic resin material in the first to fourth embodiments, magnetic body securing casing 20 of the first to fourth embodiments may be composed of a ceramic as in the present embodiment. That is, the present embodiment includes an example in which magnetic body securing casing 20 of the first to fourth embodiments is magnetic body securing casing 20LT composed of a ceramic.

A method for manufacturing irreversible circuit device 600 according to the present embodiment is basically similar to that of the fifth embodiment although magnetic body securing casing 20LT composed of a ceramic is substituted for magnetic body securing casing 20C of the fifth embodiment that is composed of a resin, and thus descriptions thereof are omitted.

Next, an operation and effect of the present embodiment are described. In addition to a similar operation and effect to the fifth embodiment, the present embodiment has the following operations and effects.

In the present embodiment, magnetic body securing casing 20LT composed of a ceramic is used. It is thus possible to achieve an effect that manufacturing of magnetic body securing casing 20LT is easier than that of magnetic body securing casing 20, 20C composed of a resin.

As magnetic body securing casing 20LT composed of a ceramic is used, it is possible to improve the reliability and heat dissipation property of irreversible circuit device 600. This is described below.

Regarding the reliability, the linear expansion coefficient of magnetic body 10 composed of rare earth garnet ferrite is approximately 10 ppm/K as described above, whereas the linear expansion coefficient of magnetic body securing casing 20LT composed of a ceramic (for example, LTCC) is approximately 7 ppm/K. The difference in linear expansion coefficient is thus approximately 3 ppm/K. The linear expansion coefficient of magnetic body securing casing 20 formed of a printed board composed of an epoxy resin in the first embodiment is approximately 16 ppm/K and the difference in linear expansion coefficient between magnetic body securing casing 20 and magnetic body 10 is approximately 6 ppm/K. If a magnetic body securing casing is composed of a ceramic, the difference in linear expansion coefficient between the magnetic body securing casing and magnetic body 10 can be reduced to a half of the difference in linear expansion coefficient when the magnetic body securing casing is composed of a resin. It is thus possible to reduce thermal stress due to the difference in linear expansion coefficient between magnetic body 10 and the magnetic body securing casing, thus reducing the possibility of damages caused by thermal stress. It is thus possible to improve the reliability of irreversible circuit device 600.

Next, regarding the heat dissipation property, as a ceramic material with higher heat dissipation property than a resin material is used for magnetic body securing casing 20LT, heat that is generated during the operation of irreversible circuit element P1 is rapidly transferred to the side of circuit board 90. It is thus possible to operate irreversible circuit device 600 more stably. Specifically, the path of heat dissipation to the side of circuit board 90 is as follows. For example, heat is transferred from conductor thin film 32 of thin board 30 that is a heat generation source through magnetic body 10 to magnetic body securing casing 20LT. Further, heat is transferred from solder ball 80 through through-conductor 23 immediately below magnetic body securing casing 20LT to circuit board 90.

Features described in the embodiments described above (examples included in the embodiments) may be applied in appropriate combination within a range where there is no technical contradiction.

It is to be understood that the disclosed embodiments are illustrative and not restrictive in all aspects. The scope of the present invention is indicated not by the above description but by the claims. It is intended that all modifications within the scope of the claims and the meaning equivalent to the claims are covered.

### REFERENCE SIGNS LIST

10 magnetic body
10A, 10B magnetic body main surface
12 elastic adhesive
13 rear conductor
20, 20C, 20LT magnetic body securing casing
20A, 20B casing main surface
20L lower-side casing
20U upper-side casing
21 casing upper-surface electrode
211 interposing upper-surface electrode
22 casing lower-surface electrode
221 interposing lower-surface electrode
23 through-conductor
24 securable part
25 joint part
26 outer frame
27 positioning pin hole
29 large casing
30 thin board
30A, 30B thin board main surface
32 conductor thin film
32A distal end part
40 ACF
40A ACF upper-side main surface
40B ACF lower-side main surface
41 heavy separator
42 light separator
43 three-layer film
44 bonder
44A bonder head
44B heating stage
44C bonder
45 pre-coated solder
46 insulating liquid adhesive
47 conductive adhesive
48 cut-away part
49 insulating adhesive film
49A film upper-side main surface
49B film lower-side main surface
50 magnet
60 yoke
70 adhesive film
80 solder ball
90 circuit board
90A circuit board main surface
91 circuit board conductor
95 irreversible circuit element mounting region
100, 200, 300, 400, 500 irreversible circuit device
GP gap part
HP solder paste
P1 irreversible circuit element
P2 mounted part
SR solder resist
SRC solder resist cavity
SRO on-conductor solder resist

## Claims

1. An irreversible circuit element comprising:
- a magnetic body;
- a magnetic body securing casing being arranged so as to surround said magnetic body; and
- a magnet being arranged on one side of said magnetic body,
wherein said magnetic body securing casing includes
- a first electrode on one casing main surface being arranged on said one side,
- a second electrode on the other casing main surface being arranged on the other side opposite to said one side, and
- a through-conductor passing through said magnetic body securing casing and electrically connecting said first electrode to said second electrode,
said first electrode being connected to a first wiring arranged on said one side of said magnetic body.

2. The irreversible circuit element according to claim 1,
wherein said first wiring includes three conductor terminals, and
a unit of said first electrode, said second electrode, and said through-conductor is formed to be electrically connected to each of said three conductor terminals.

3. The irreversible circuit element according to claim 1 or 2,
further comprising a thin board being arranged in a region between said magnet and said magnetic body, and in at least a part of a region on said one side of said magnetic body securing casing,
wherein said thin board includes a conductor thin film as said first wiring only on a thin board main surface on a side of said magnetic body.

4. The irreversible circuit element according to claim 3,
wherein a securable part that can secure said magnetic body so as to surround said magnetic body is formed in a center part of said magnetic body securing casing in a planar view,
said magnetic body is connected to an inner wall surface of said securable part with an elastic adhesive interposed therebetween, and
an adhesive member is arranged between said thin board and said magnetic body.

5. The irreversible circuit element according to claim 4,
including an overlapping part of said first electrode of said magnetic body securing casing and said first wiring in a planar view,
wherein a conductive member for connecting said first electrode to said first wiring is arranged between said first electrode and said first wiring in said overlapping part.

6. The irreversible circuit element according to claim 5,
wherein said adhesive member is configured to be integrated with said conductive member,
said conductive member has anisotropic conductivity, and
said conductive member extends from a region between said thin board and said magnetic body to a region between said thin board and said magnetic body securing casing.

7. The irreversible circuit element according to claim 5,
wherein said adhesive member is an insulating thin film,
an outer edge of said insulating thin film includes a cut-away part spaced apart from said first electrode in a planar view, and
said conductive member is a conductive adhesive arranged to be spaced away from said insulating thin film.

8. The irreversible circuit element according to claim 5,
wherein said adhesive member is a liquid adhesive having an insulating property, said liquid adhesive is arranged only in a region between said thin board and said magnetic body, and
said conductive member is a solder.

9. The irreversible circuit element according to any one of claims 4 to 8,
wherein said magnetic body securing casing includes a first magnetic body securing casing part arranged so as to surround said magnetic body from an outer circumferential side of said magnetic body in a planar view and a second magnetic body securing casing part arranged so as to cover said magnetic body from said other side,
said first magnetic body securing casing part includes said securable part, and said magnetic body is arranged in a recess part formed as said securable part by said first magnetic body securing casing part and said second magnetic body securing casing part.

10. The irreversible circuit element according to any one of claims 5 to 8,
wherein said magnetic body securing casing is configured by integrating a first part arranged so as to surround said securable part from an outer circumferential side in a planar view with a second part arranged so as to cover said securable part from said other side, and
said magnetic body is secured to said second part without arranging said conductive member in said securable part.

11. The irreversible circuit element according to any one of claims 6 to 10,
wherein said magnetic body securing casing is composed of a ceramic.

12. The irreversible circuit element according to any one of claims 1 to 8,
further comprising:
- a rear conductor being arranged only on said other side of said magnetic body;
and
- a solder resist being arranged on a surface on said other side of said rear conductor and on said other casing main surface.

13. The irreversible circuit element according to any one of claims 1 to 12,
wherein said magnetic body includes a plurality of magnetic body layers, and
at least one metal plate is joined to said other side of said magnetic body including said plurality of magnetic body layers.

14. An irreversible circuit device further comprising a solder ball being arranged on a surface of said other side of said magnetic body securing casing in the irreversible circuit element according to any one of claims 1 to 13,
wherein a circuit board joined to said other side of said solder ball is arranged, said circuit board includes a second wiring, and
said second electrode is connected to a second wiring arranged on said other side of said magnetic body.

15. The irreversible circuit device according to claim 14,
wherein said second wiring includes an earth electrode.

16. A method for manufacturing an irreversible circuit element, comprising the steps of:
- preparing a magnetic body;
- arranging a magnetic body securing casing so as to surround said magnetic body;
- arranging a magnet on one side of said magnetic body;
- forming a first electrode on one casing main surface arranged on said one side of said magnetic body securing casing;
- forming a second electrode on the other casing main surface arranged on the other side of said magnetic body securing casing opposite to said one side;
- forming a through-conductor passing through said magnetic body securing casing and electrically connecting said first electrode to said second electrode; and
- connecting said first electrode to a first wiring arranged on said one side of said magnetic body.

17. The method for manufacturing an irreversible circuit element according to claim 16, further comprising the steps of:
- forming a thin board in which a conductor thin film is formed as said first wiring only on a thin board main surface on said other side;
- arranging said thin board so as to include said magnetic body and at least a part of a region on said one side of said magnetic body securing casing; and
- adhesion-securing said thin board, said magnetic body, and said magnetic body securing casing from a region on said one side of said magnetic body securing casing to a region overlapping said magnetic body in a planar view by using an adhesive function of a conductive member having anisotropic conductivity, thus electrically connecting said thin board, said magnetic body, and said magnetic body securing casing.

18. A method for manufacturing an irreversible circuit device, further comprising the steps of:
arranging a solder ball on a surface on said other side of said magnetic body securing casing in the irreversible circuit element according to claim 16 or 17; and
joining said solder ball to a circuit board,
wherein said circuit board is formed so as to include a second wiring, and
said second electrode is connected to a second wiring arranged on said other side of said magnetic body.
